(19) **Europäisches Patentamt**
**European Patent Office**
**Office européen des brevets**

(11) **EP 2 787 104 B1**

(12) **EUROPEAN PATENT SPECIFICATION**

(45) Date of publication and mention
of the grant of the patent:
**18.05.2016 Bulletin 2016/20**

(51) Int Cl.:
*C30B 9/10* (2006.01)       *C30B 9/12* (2006.01)
*C30B 29/40* (2006.01)

(21) Application number: **14157492.1**

(22) Date of filing: **03.03.2014**

(54) **Method for producing group 13 nitride crystal and apparatus for producing the same**

Verfahren zur Herstellung von 13 Nitridkristall der Gruppe 13 und Vorrichtung zu seiner Herstellung

Procédé de production de cristaux de nitrure du groupe 13 et son appareil de production

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.03.2013 JP 2013051056**

(43) Date of publication of application:
**08.10.2014 Bulletin 2014/41**

(73) Proprietor: **Ricoh Company, Ltd.**
**Tokyo 143-8555 (JP)**

(72) Inventors:
• **Satoh, Takashi**
  **Tokyo 143-8555 (JP)**
• **Sarayama, Seiji**
  **Tokyo 143-8555 (JP)**
• **Hayashi, Masahiro**
  **Tokyo 143-8555 (JP)**
• **Miyoshi, Naoya**
  **Tokyo 143-8555 (JP)**

(74) Representative: **Leeming, John Gerard**
**J A Kemp**
**14 South Square**
**Gray's Inn**
**London WC1R 5JJ (GB)**

(56) References cited:
**EP-A1- 1 806 437**       **WO-A1-2013/021804**
**JP-A- 2010 168 236**     **US-A1- 2011 274 609**

• BELLMANN M P ET AL: "Effect of accelerated crucible rotation on the segregation of impurities in vertical Bridgman growth of multi-crystalline silicon", JOURNAL OF CRYSTAL GROWTH, vol. 318, no. 1, 26 October 2010 (2010-10-26), pages 239-243, XP028164356, ISSN: 0022-0248, DOI: 10.1016/J.JCRYSGRO.2010.10.069 [retrieved on 2010-10-26]
• SCHEEL ET AL: "Accelerated crucible rotation: A novel stirring technique in high-temperature solution growth", JOURNAL OF CRYSTAL GROWTH, ELSEVIER, AMSTERDAM, NL, vol. 13-14, 1 May 1972 (1972-05-01), pages 560-565, XP024732583, ISSN: 0022-0248, DOI: 10.1016/0022-0248(72)90516-7 [retrieved on 1972-05-01]
• KASHIWAGI D ET AL: "Global analysis of GaN growth using a solution technique", JOURNAL OF CRYSTAL GROWTH, ELSEVIER, AMSTERDAM, NL, vol. 310, no. 7-9, 1 April 2008 (2008-04-01), pages 1790-1793, XP022697532, ISSN: 0022-0248, DOI: 10.1016/J.JCRYSGRO.2007.10.061 [retrieved on 2007-10-30]

EP 2 787 104 B1

**Description**

The present invention relates to a method for producing a group 13 nitride crystal and a production apparatus used for the method.

A method for growing nitride crystals such as gallium nitride on a seed crystal using the flux method to produce group 13 nitride crystals has been well known. As the production method using the flux method, a method for growing a crystal from a seed crystal in a crucible retaining a mixed melt containing a flux and materials during crystal growth has been known.

In addition, techniques for producing high-quality semiconductor crystals have also been disclosed. For example, techniques have been disclosed in which a crucible is shaken, a crucible is rotated, or a mixed melt is stirred during crystal growth (see, for example, Japanese Patent No. 4189423, Japanese Laid-open Patent Publication No. 2007-277055, and Japanese Laid-open Patent Publication No. 2007-254161). Furthermore, the following technique has been disclosed: a crucible retaining a flux mixture is rotated during crystal growth while alternately switching between positive rotation and negative rotation, and the rotation is switched after the flow rate of the flux mixture decreases to 0.1 times the maximum flow rate or lower (see Japanese Laid-open Patent Publication No. 2010-83711).

However, the techniques in Japanese Patent No. 4189423, Japanese Laid-open Patent Publication No. 2007-277055, and Japanese Laid-open Patent Publication No. 2007-254161 have produced semiconductor crystals by simply shaking or rotating the crucible, or stirring the mixed melt, and may have deteriorated crystal quality. The technique in Japanese Laid-open Patent Publication No. 2010-83711 may also have deteriorated crystal quality. Therefore, it has been conventionally difficult to provide a method for producing a high-quality group 13 nitride crystal suitable for producing semiconductor devices.

WO 2013/021804 A1 discloses a method of peeling a film of a nitride of group 13 element from a seed crystal substrate.

In view of the above-mentioned problems, there is a need to provide a method for producing a high-quality group 13 nitride crystal.

It is an aim of the present invention to at least partially solve the problems in the conventional technology.

According to the present invention, there are provided a method for producing a group 13 nitride crystal and a production apparatus as defined in the independent claims.

The above and other aims, features, advantages and technical and industrial significance of this invention will be better understood by reading the following detailed description of presently preferred embodiments of the invention, when considered in connection with the accompanying drawings, in which:

FIG. 1 is a schematic diagram illustrating an example of a production apparatus according to the present embodiment.
FIG. 2 is a schematic diagram illustrating an example of a seed crystal.
FIG. 3 is a cross-sectional view of a seed crystal.
FIG. 4 is a schematic diagram illustrating an example of a production apparatus.
FIG. 5 is a schematic diagram illustrating an example of a production apparatus.
FIG. 6 is a schematic diagram illustrating an example of a production apparatus.
FIG. 7 is a schematic diagram illustrating an example of a pattern and control information.
FIG. 8 is a schematic diagram illustrating an example of a pattern and control information.
FIG. 9 is a schematic diagram illustrating an example of a pattern and control information.
FIG. 10 is a schematic diagram illustrating an example of a pattern and control information.
FIG. 11 is a schematic diagram illustrating an example of a pattern and control information.
FIG. 12 is a schematic diagram illustrating an example of a pattern and control information.
FIG. 13 is a schematic diagram illustrating an example of a pattern and control information.
FIG. 14 is a schematic diagram illustrating an example of a pattern and control information.
FIG. 15 is a schematic diagram illustrating an example of a pattern and control information.
FIG. 16 is a schematic diagram illustrating an example of a pattern and control information.
FIG. 17 is a schematic diagram illustrating an example of a pattern and control information.
FIG. 18 is a schematic diagram illustrating an example of a pattern and control information.
FIG. 19 is a schematic diagram illustrating an example of a pattern and control information.
FIG. 20 is a schematic diagram illustrating an example of a pattern and control information.
FIG. 21 is a schematic diagram illustrating an example of a pattern and control information.
FIG. 22 is a schematic diagram illustrating an example of a pattern and control information.
FIG. 23 is a schematic diagram illustrating an example of a pattern and control information.
FIG. 24 is a schematic diagram illustrating an example of a pattern and control information.
FIG. 25 is a schematic diagram illustrating an example of a pattern and control information.
FIG. 26 is a schematic diagram illustrating an example of a pattern and control information.

FIG. 27 is a schematic diagram illustrating an example of a pattern and control information.
FIG. 28 is a schematic diagram illustrating an example of a pattern and control information.
FIG. 29 is a schematic diagram illustrating an example of a pattern and control information.
FIG. 30 is a schematic diagram illustrating an example of a pattern and control information.
FIG. 31 is a schematic diagram illustrating an example of a pattern and control information.
FIG. 32 is a schematic diagram illustrating an example of a pattern and control information.
FIG. 33 is a schematic diagram illustrating an example of a pattern and control information.
FIG. 34 is a schematic diagram illustrating an example of a pattern and control information.
FIG. 35 is a schematic diagram illustrating an example of a pattern and control information.
FIG. 36 is a schematic diagram illustrating an example of a pattern and control information.
FIG. 37 is a schematic diagram illustrating an example of a pattern and control information.
FIGS. 38(A) and 38(B) are schematic diagrams illustrating an example of a production apparatus.
FIG. 39 is a diagram illustrating the relative speed and the rotation speed of each of a seed crystal and a mixed melt in Comparative Example 1.

A method for producing a group 13 nitride crystal and an apparatus for producing the same according to the present embodiment will be described below with reference to the accompanying drawings. In the following description, the shape, size, and arrangement of constituent elements in the figures are schematically illustrated only to understand the present invention, and the present invention is not particularly limited to these. The same constituent elements illustrated in the figures are denoted by the same reference numerals, and redundant descriptions thereof may be omitted.

In the method for producing a group 13 nitride crystal according to the present embodiment, the group 13 nitride crystal is produced by growing a nitride crystal from a seed crystal according to the flux method.

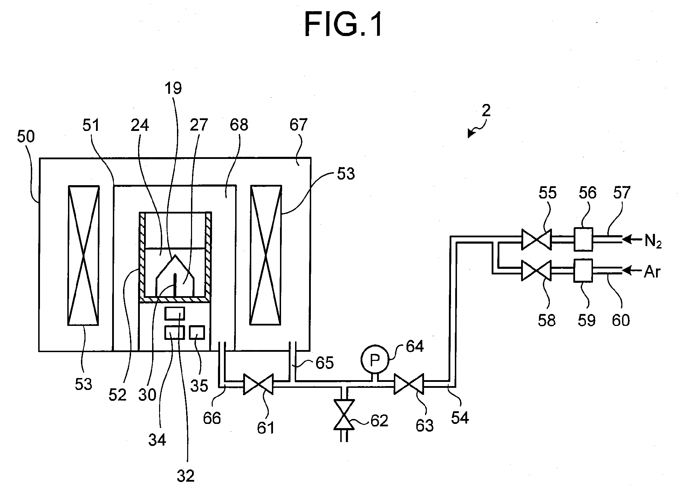

FIG. 1 is a schematic diagram illustrating an example of a production apparatus 2 according to the present embodiment.

The production apparatus 2 includes an outer pressure resistant vessel 50. The outer pressure resistant vessel 50 is made of, for example, stainless steel. The outer pressure resistant vessel 50 includes an inner vessel 51 disposed therein. The inner vessel 51 further accommodates a reaction vessel 52. The inner vessel 51 is removably attached to the outer pressure resistant vessel 50.

The reaction vessel 52 is a vessel for retaining a seed crystal 30 and a mixed melt 24 to grow a nitride crystal 27 from the seed crystal 30.

The seed crystal 30 is a nitride crystal used in the method for producing a group 13 nitride crystal according to the present embodiment. The seed crystal 30 may be a seed crystal from which a nitride crystal is grown according to the flux method to produce a group 13 nitride crystal, and the form of the seed crystal 30 is not limited. For example, a well-known seed crystal used in the flux method can be used as the seed crystal 30.

Specifically, a substrate having a GaN film formed as a crystal growth layer (for example, a seed crystal described in Japanese Laid-open Patent Publication No. 2007-277055) may be used as the seed crystal 30, or a needle-like crystal as described in Japanese Laid-open Patent Publication No. 2011-213579 may be used as the seed crystal.

The method for producing a group 13 nitride crystal according to the present embodiment preferably uses a long seed crystal described in Japanese Laid-open Patent Publication No. 2011-213579 as the seed crystal 30 from the viewpoint of producing a group 13 nitride crystal having a higher quality. The group 13 nitride crystal produced in the production apparatus 2 may be further used as the seed crystal 30.

In the present embodiment, the "group 13 nitride crystal having a higher quality" indicates high crystal quality. The high crystal quality indicates that the amount of inclusions contained in the produced group 13 nitride crystal is lower than that without using the production method of the present embodiment. The inclusions are materials used as a flux in a crystal growth step and incorporated in a crystal growth process.

The flux contains at least one of alkali metals, alkaline earth metals, and mixtures of these. The alkali metal is at least one selected from sodium (Na), lithium (Li), and potassium (K). Preferred is sodium (Na) or potassium (K). The alkaline earth metal is at least one selected from calcium (Ca), magnesium (Mg), strontium (Sr), and barium (Ba). In the following description, the flux and the inclusions may be referred to simply as an alkali metal(s), but it is understood that the flux and the inclusions may include other above-mentioned metals than alkali metals.

Hereinafter, the case where a needle-like seed crystal (gallium nitride crystal) is used as the seed crystal 30 will be described in the present embodiment. As described above, the crystal used as the seed crystal 30 is not limited to needle-like one and may be rod-like or plate-like one. The shape of the seed crystal 30 is not limited.

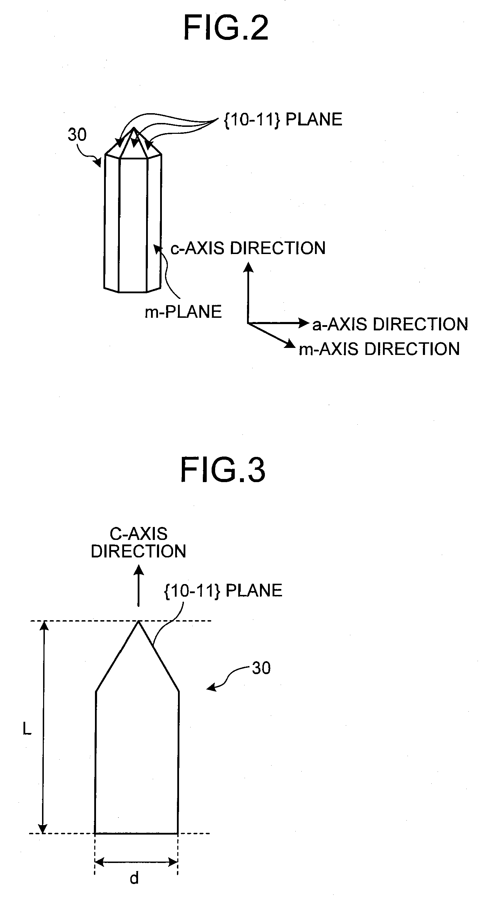

FIG. 2 is a schematic diagram illustrating an example of the seed crystal 30 used in the method for producing a group 13 nitride crystal according to the present embodiment. FIG. 3 is a cross-sectional view of the seed crystal 30.

FIG. 2 illustrates the case where the seed crystal 30 used in the present embodiment is a gallium nitride crystal with a hexagonal crystal structure (hexagonal structure). The seed crystal 30 has m-planes and {10-11} planes. The seed crystal 30 may have a hexagonal columnar shape with m-planes and c-planes, or may have a shape with a c-plane formed in the vertex part of the hexagonal pyramid of the seed crystal 30 illustrated in FIG. 2.

In the present embodiment, the c-plane, which is a cross-section perpendicular to the c-axis, has a hexagonal shape in the seed crystal 30. In the present embodiment, the hexagonal shape includes a regular hexagonal shape and hexagonal shapes other than a regular hexagonal shape. The sides of the seed crystal 30 corresponding to the sides of this hexagonal shape are mainly composed of m-planes, i.e., {10-10} planes, of the crystal structure of the hexagonal crystal.

FIG. 3 illustrates a cross-sectional view parallel to the c-axis and a-axis in the seed crystal 30 illustrated in FIG. 2. Although the length of the seed crystal 30 in the c-axis direction is not limited, the gallium nitride crystal with a hexagonal crystal structure in which the ratio of a maximum length L in the c-axis direction to a maximum diameter d of the c-plane, i.e., the ratio L/d, is larger than 0.813 is preferably used from the viewpoint of producing a group 13 nitride crystal having a larger c-plane.

As described above, the seed crystal 30 preferably has the above shape, but the seed crystal 30 is not limited to needle-like or long ones and may be plate-like one or others.

Returning to FIG. 1, the reaction vessel 52 retains the mixed melt 24 thereinside, and the mixed melt 24 retains the seed crystal 30 so that the seed crystal 30 is immersed in the mixed melt 24. The example illustrated in FIG. 1 shows the state where the seed crystal 30 is installed at the inside bottom of the reaction vessel 52.

The material of the reaction vessel 52 is not particularly limited, and nitrides such as BN sintered compacts and P-BN, oxides such as alumina and YAG, carbides such as SiC, and others are used. An inner wall surface of the reaction vessel 52, i.e., the part where the reaction vessel 52 is in contact with the mixed melt 24, is desirably made of a material non-reactive with the mixed melt 24. Examples of the material may include nitrides such as boron nitride (BN), pyrolytic BN (P-BN), and aluminum nitride; oxides such as alumina, yttrium aluminum garnet (YAG); and stainless steel (SUS).

The outer pressure resistant vessel 50 and the inner vessel 51 are respectively connected to gas supply pipes 65 and 66 which supply nitrogen ($N_2$) gas which is a material of a group 13 nitride crystal 19 and a diluent gas for adjusting the total pressure to an internal space 67 of the outer pressure resistant vessel 50 and an internal space 68 of the inner vessel 51. The gas supply pipe 54 is branched into a nitrogen supply pipe 57 and a gas supply pipe 60. These pipes 57 and 60 can be detached at valves 55 and 58, respectively.

Argon (Ar) gas, an inert gas, is desirably used as the diluent gas, but the diluent gas is not limited to this. Other inert gases such as helium (He) may be used as the diluent gas.

Nitrogen gas is introduced from the nitrogen supply pipe 57 connected to a nitrogen gas cylinder or the like. After adjusting the pressure with a pressure controller 56, the nitrogen gas is supplied to the gas supply pipe 54 via the valve 55. On the other hand, the gas (for example, argon gas) for adjusting the total pressure is introduced from the gas supply pipe 60 for adjusting the total pressure connected to a gas cylinder or the like of the gas for adjusting the total pressure or others. After adjusting the pressure with a pressure controller 59, the gas for adjusting the total pressure is supplied to the gas supply pipe 54 via the valve 58. In this manner, the pressure-adjusted nitrogen gas and gas for adjusting the total pressure are supplied to the gas supply pipe 54 and mixed.

The gas mixture of nitrogen and the diluent gas is then supplied to the insides of the outer pressure resistant vessel 50 and the inner vessel 51 from the gas supply pipe 54 via the valve 63, the gas supply pipe 65, the valve 61, and the gas supply pipe 66. The inner vessel 51 can be detached from the production apparatus 2 at the valve 61. The gas supply pipe 65 is connected to outside via the valve 62.

The gas supply pipe 54 is provided with a pressure gauge 64. The pressure in the outer pressure resistant vessel 50 and the inner vessel 51 can be adjusted while monitoring the total pressure in the outer pressure resistant vessel 50 and the inner vessel 51 with the pressure gauge 64.

In the present embodiment, the nitrogen partial pressure can be adjusted by controlling the pressure of the nitrogen gas and the diluent gas in this manner with the valves 55 and 58 and the pressure controllers 56 and 59. Since the total pressure in the outer pressure resistant vessel 50 and the inner vessel 51 can be adjusted, the total pressure in the inner vessel 51 can be increased to suppress evaporation of the flux (for example, sodium) in the reaction vessel 52. In other words, it is possible to control separately the nitrogen partial pressure serving as a nitrogen material which affects the crystal growth conditions of gallium nitride, and the total pressure which affects suppression of the evaporation of the flux such as sodium.

As illustrated in FIG. 1, a heater 53 is disposed around the inner vessel 51 in the outer pressure resistant vessel 50. The heater 53 heats the inner vessel 51 and the reaction vessel 52 to adjust the temperature of the mixed melt 24.

The seed crystal 30 is installed in the reaction vessel 52. Into the reaction vessel 52, the mixed melt 24 containing: a material including at least a group 13 metal; and a substance(s) used as the flux as described above is charged. In the present embodiment, the case where alkali metal Na is used as the flux is described, but the flux is not limited to Na.

The process of charging the seed crystal 30, the material, the flux, and an additive such as C, a dopant such as Ge, and others into the reaction vessel 52 is performed while, for example, the inner vessel 51 is placed in a glove box with an inert gas atmosphere such as argon gas. This process may be performed while the reaction vessel 52 is placed in the inner vessel 51.

In the present embodiment, the case where gallium is used as a substance containing a group 13 metal serving as the material is described. As the group 13 metal(s), other group 13 metals, such as boron, aluminum, and indium, may be used, or a mixture of two or more metals selected from group 13 metals may be used.

Although the molar ratio of the group 13 metal(s) to the alkali metal(s) which are contained in the mixed melt 24 is not particularly limited, the molar ratio of the alkali metal(s) to the total mole number of the group 13 metal(s) and the alkali metal(s) is preferably set to 40% to 95%.

After the material and others are installed in this manner, the heater 53 is energized to heat the inner vessel 51 and the reaction vessel 52 therein to a crystal growth temperature. In the reaction vessel 52, the group 13 metal(s) of the material, the alkali metal(s), other additives, and others are melted to form the mixed melt 24. The mixed melt 24 is brought into contact with the nitrogen with the above-described partial pressure so that the nitrogen is dissolved in the mixed melt 24, thereby supplying nitrogen as a material of the group 13 nitride crystal 19 into the mixed melt 24.

The materials dissolved in the mixed melt 24 are then supplied to the peripheral surface of the seed crystal 30, so that the materials allow the nitride crystal 27 to grow from the peripheral surface of the seed crystal 30 (crystal growth step). This produces the group 13 nitride crystal 19.

In this manner, the production apparatus 2 can produce the group 13 nitride crystal 19 by growing the nitride crystal 27 from the peripheral surface of the seed crystal 30.

In the present embodiment, the production apparatus 2 includes a drive unit 32, a control unit 34, and a storage unit 35.

The drive unit 32 rotates at least one of the mixed melt 24 and the seed crystal 30 which are retained in the reaction vessel 52. A well-known motor or the like can be used for the drive unit 32.

The control unit 34 controls the drive of the drive unit 32 to rotate at least one of the mixed melt 24 and the seed crystal 30. The control unit 34 controls each unit provided in the production apparatus 2. The storage unit 35 is a storage medium for storing various data (details will be described below).

In the present embodiment, the drive unit 32 may be configured to rotate at least one of the mixed melt 24 and the seed crystal 30 directly or through various supporting members or the like, and the configuration of the drive unit 32 is not limited.

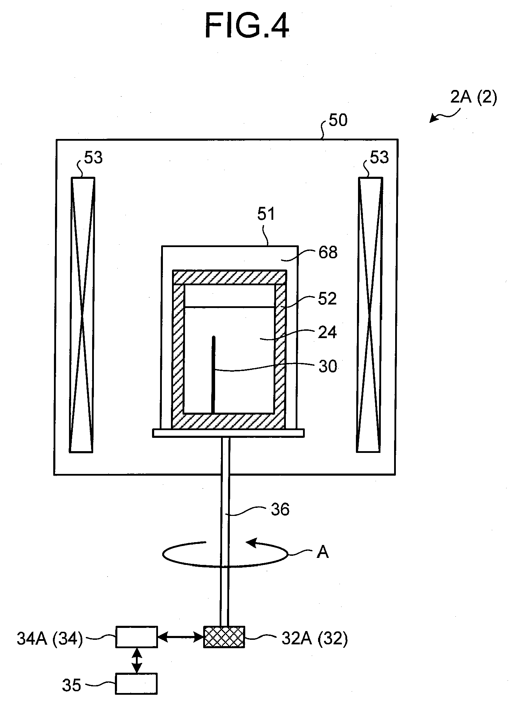

FIGS. 4 to 6 are schematic diagrams illustrating respective configurations of several types of production apparatuses 2 (2A to 2C) with different rotation mechanisms for the at least one of the mixed melt 24 and the seed crystal 30 by way of the drive unit 32.

FIG. 4 is a schematic diagram illustrating the configuration of the production apparatus 2A. The production apparatus 2A includes a drive unit 32A and a control unit 34A instead of the drive unit 32 and the control unit 34, and has the same configuration as the production apparatus 2 in FIG. 1 except for further including a supporting member 36.

In the production apparatus 2A, the seed crystal 30 is fixed to the inside bottom of the reaction vessel 52, and the rotation of the reaction vessel 52 is controlled by controlling the drive unit 32A through the control unit 34A, thereby rotating the mixed melt 24 and the seed crystal 30 which are retained in the reaction vessel 52.

In FIG. 4, the drive unit 32A is electrically connected to the control unit 34A. The control unit 34A controls the drive unit 32A as well as the entire production apparatus 2A. The production apparatus 2A includes the rod-like supporting member 36 which supports the reaction vessel 52. One end of the supporting member 36 in the longitudinal direction is fixed to the bottom of the reaction vessel 52, and the other end is fixed to the drive unit 32A. The one end of the supporting member 36 in the longitudinal direction is fixed to the bottom of the reaction vessel 52 at the position corresponding to the center of the horizontal cross section of the reaction vessel 52.

The drive unit 32A drives under the control of the control unit 34A, so that the driving force of the drive unit 32A is transmitted to the reaction vessel 52 via the supporting member 36. Accordingly, the reaction vessel 52 rotates about the supporting member 36 as a rotation axis (see the direction of an arrowed line A in FIG. 4).

The seed crystal 30 is fixed to the inside bottom of the reaction vessel 52 in the example illustrated in FIG. 4. Specifically, one end of the seed crystal 30 in the longitudinal direction is fixed to the inside bottom of the reaction vessel 52. In the present embodiment, it is preferable that the seed crystal 30 is installed at the position where the longitudinal direction of the seed crystal 30 is coincident with the rotation axis of the reaction vessel 52, but the manner of installing the seed crystal 30 is not limited to such a form.

Therefore, when the reaction vessel 52 rotates in accordance with the control of the drive unit 32A by the control unit 34A, the seed crystal 30 fixed to the bottom of the reaction vessel 52 will also rotate with the rotation of the reaction vessel 52, in the example illustrated in FIG. 4.

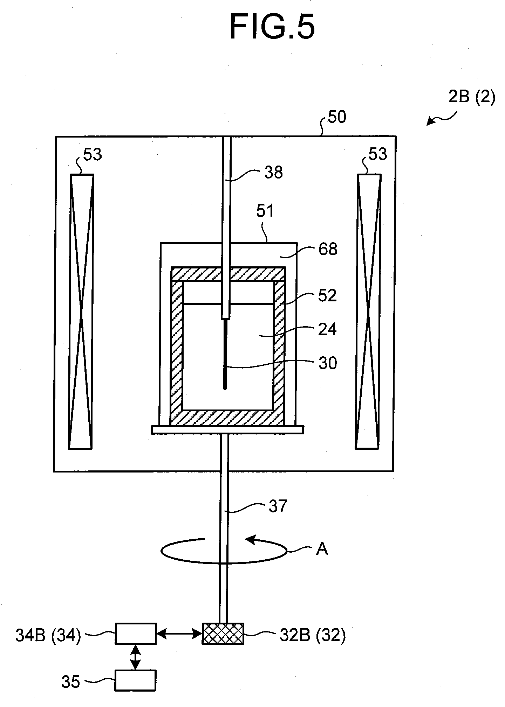

FIG. 5 is a schematic diagram illustrating the configuration of the production apparatus 2B. The production apparatus 2B includes a drive unit 32B and a control unit 34B instead of the drive unit 32 and the control unit 34, and has the same configuration as the production apparatus 2 in FIG. 1 except that a seed crystal 30 is fixed to an outer pressure resistant vessel 50 through a supporting member 38.

In the production apparatus 2B, the seed crystal 30 is fixed to the outer pressure resistant vessel 50, and the rotation of the reaction vessel 52 is controlled by controlling the drive unit 32B through the control unit 34B, thereby rotating a mixed melt 24 retained in the reaction vessel 52.

The drive unit 32B is electrically connected to the control unit 34B. The control unit 34B controls the drive unit 32B as well as the entire production apparatus 2B. The production apparatus 2B includes a rod-like supporting member 37 which supports the reaction vessel 52. One end of the supporting member 37 in the longitudinal direction is fixed to the bottom of the reaction vessel 52, and the other end is fixed to the drive unit 32B. The one end of the supporting member 37 in the longitudinal direction is fixed to the bottom of the reaction vessel 52 at the position corresponding to the center of the horizontal cross section of the reaction vessel 52.

In the example illustrated in FIG. 5, one end of the long supporting member 38 is fixed to an inner wall of the external pressure resistant vessel 50. The other end of the supporting member 38 in the longitudinal direction is fixed to one end of the seed crystal 30 in the longitudinal direction.

The drive unit 32B drives under the control of the control unit 34B, so that the driving force of the drive unit 32B is transmitted to the reaction vessel 52 via the supporting member 37. Accordingly, the reaction vessel 52 rotates about the supporting member 37 as a rotation axis (see the direction of an arrowed line A in FIG. 5). As the reaction vessel 52 rotates, the mixed melt 24 retained in the reaction vessel 52 rotates.

The seed crystal 30 is fixed by the supporting member 38 fixed to the external pressure resistant vessel 50 in the example illustrated in FIG. 5. For this reason, the seed crystal 30 is not allowed to rotate while being fixed in the example illustrated in FIG. 5.

In the case of the production apparatus 2B with the configuration illustrated in FIG. 5, the control unit 34B accordingly controls the rotation of the mixed melt 24 retained in the reaction vessel 52 by controlling the rotation of the reaction vessel 52. The seed crystal 30 is not allowed to rotate in the example illustrated in FIG. 5.

FIG. 5 describes the case where the seed crystal 30 is provided at one end of the supporting member 38 in the longitudinal direction, but the manner of supporting the seed crystal 30 is not limited to such a form. For example, the seed crystal 30 may be provided at the side of one end side of the supporting member 38 in the longitudinal direction. That is, the seed crystal 30 may be installed so that an axis line along the longitudinal direction of the seed crystal 30 is not aligned with an axis line along the longitudinal direction of the supporting member 38.

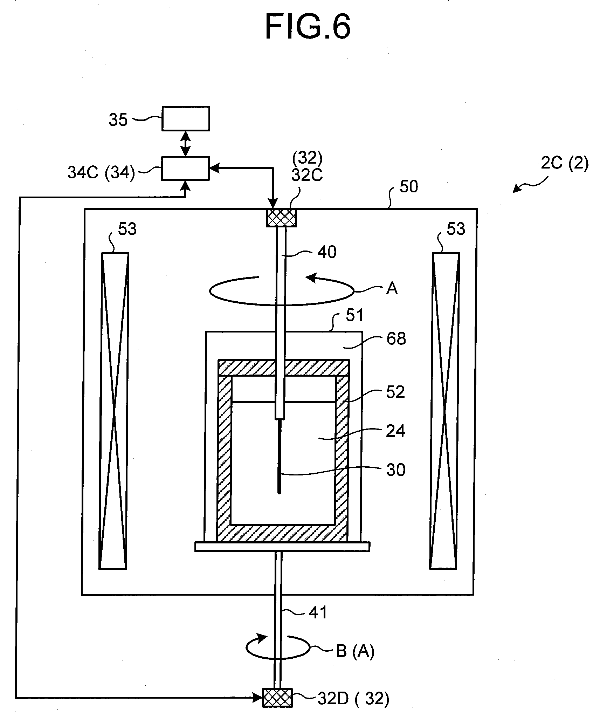

FIG. 6 is a schematic diagram illustrating the configuration of the production apparatus 2C. The production apparatus 2C has the same configuration as the production apparatus 2 in FIG. 1 except for including a drive unit 32C, a drive unit 32D, and a control unit 34C instead of the drive unit 32 and the control unit 34.

In the production apparatus 2C illustrated in FIG. 6, both of a reaction vessel 52 and a seed crystal 30 are rotated.

In the production apparatus 2C, the drive unit 32C is electrically connected to the control unit 34C. The drive unit 32D is electrically connected to the control unit 34C. In the production apparatus 2C, the seed crystal 30 is provided at the other end of a supporting member 40.

The control unit 34C controls the drive unit 32C and the drive unit 32D as well as the entire production apparatus 2C. The drive unit 32C is fixed to an inner wall of an external pressure resistant vessel 50 in the example illustrated in FIG. 6. One end of the long supporting member 40 is fixed to the drive unit 32C. The seed crystal 30 is retained at the other end of the supporting member 40. The seed crystal 30 is immersed in a mixed melt 24 retained in the reaction vessel 52.

Although not shown in the figure, a stirrer with a shape (for example, propeller shape) capable of stirring the mixed melt 24 may be installed in the mixed melt 24. The stirrer may be any member capable of stirring the mixed melt 24, and may be provided to rotate with the rotation of the supporting member 40 to thereby stir the mixed melt 24.

The rotation axes of the supporting member 40 and the seed crystal 30 are parallel to the crystal growth direction of the seed crystal 30, and further provided to be coincident with the rotation center of the rotating mixed melt 24. In the production apparatus 2C illustrated in FIG. 6, axis lines along the longitudinal directions of the supporting member 40 and the seed crystal 30 are adjusted to be coincident with each other. That is, the axis lines along the longitudinal directions and the rotation axes of the supporting members 40 and the seed crystal 30 are adjusted to be coincident with each other, respectively.

The drive unit 32C drives under the control of the control unit 34C, so that the driving force of the drive unit 32C is transmitted to the supporting member 40. This rotates the supporting member 40, and the seed crystal 30 rotates with the rotation of the supporting member 40, thereby rotating the stirrer (not shown) and the mixed melt 24 (see the direction of an arrowed line A in FIG. 6).

The production apparatus 2C includes a rod-like supporting member 41 which supports the reaction vessel 52. One end of the supporting member 41 in the longitudinal direction is fixed to the bottom of the reaction vessel 52, and the other end is fixed to the drive unit 32D. The one end of the supporting member 41 in the longitudinal direction is fixed to the bottom of the reaction vessel 52 at the position corresponding to the center of the horizontal cross section of the reaction vessel 52.

The drive unit 32D drives under the control of the control unit 34C, so that the driving force of the drive unit 32D is transmitted to the reaction vessel 52 via the supporting member 41. Accordingly, the reaction vessel 52 rotates about the supporting member 41 as a rotation axis (the direction of an arrowed line B in FIG. 6).

The control unit 34C controls the rotation direction and the rotation speed of the seed crystal 40 and the reaction vessel 52 separately. For example, the control unit 34C may control the rotation directions of the seed crystal 40 and the reaction vessel 52 so that these directions are the same (the direction of the arrowed line A in FIG. 6), or may control the rotation direction of the seed crystal 40 (the direction of the arrowed line A in FIG. 6) and the rotation direction of the reaction vessel 52 (the direction of the arrowed line B in FIG. 6) so that these directions are opposite to each other. Furthermore, for example, the control unit 34C may control the rotation speeds, accelerations, or others of the seed crystal 40 and the reaction vessel 52 so that they are the same respectively, or may control them separately.

In the examples illustrated in FIGS. 4 to 6, the cases where the seed crystal 30 is installed at the position corresponding to the center of the horizontal cross section of the reaction vessel 52 are described, but the installation of the seed crystal 30 is not limited to the installation at the position corresponding to the center of the cross section. The seed crystal 30 is preferably provided at the position coincident with the rotation axis of the reaction vessel 52. The installation position of the seed crystal 30 is not limited to the position coincident with the rotation axis of the reaction vessel 52.

However, it is preferable that the seed crystal 30 be installed at the position corresponding to the center of the horizontal cross section of the reaction vessel 52 and further installed at the position coincident with the rotation axis of the reaction vessel 52. This is considered to be because when a needle-like seed crystal is used as the seed crystal 30, the crystal growth proceeds in both of the m-axis direction and the c-axis direction of the periphery of the seed crystal 30, and thus the installation of the seed crystal 30 at the above position allows production of a group 13 nitride crystal having a higher quality.

Returning to FIG. 1, the production apparatus 2 has any of the configurations illustrated in the production apparatuses 2A to 2C and accordingly rotates at least one of the mixed melt 24 and the seed crystal 30 which are retained in the reaction vessel 52, in the present embodiment. Therefore, the production apparatus 2 of the present embodiment may have any of the configurations of the production apparatuses 2A to 2C.

A construction having a plate-shape, cylindrical shape, or other shapes may be further installed in the reaction vessel 52.

In the following description, the production apparatuses 2A to 2C may be collectively referred to simply as the production apparatus 2, the control units 34A to 34C may be collectively referred to simply as the control unit 34, and the drive units 32A to 32C may be collectively referred to simply as the drive unit 32.

In the crystal growth step from the seed crystal 30 in the production apparatus 2, the control unit 34 controls the drive unit 32 to rotate at least one of the mixed melt 24 and the seed crystal 30. The control unit 34 controls the drive unit 32 so that the relative speed between the mixed melt 24 and the seed crystal 30 in the crystal growth step is repeatedly fluctuated in accordance with one or a plurality of types of predetermined patterns, and further the maximum value of the relative speed in each pattern is 0.01 m/s or more.

The relative speed between the mixed melt 24 and the seed crystal 30 refers to the absolute value of the relative speed of the seed crystal 30 to the mixed melt 24. The relative speed between the mixed melt 24 and the seed crystal 30 has the same meaning as the absolute value of the relative speed of the mixed melt 24 to the seed crystal 30. In the following description, the relative speed between the mixed melt 24 and the seed crystal 30 may be referred to simply as the relative speed.

The one or plurality of types of patterns are stored in advance in the storage unit 35.

The pattern is a waveform indicating one cycle of fluctuations in the relative speed. Specifically, the pattern is represented by the waveform indicating one cycle of fluctuations (increase and decrease) in the relative speed over elapsed time. The fluctuations in the relative speed indicated by each pattern are realized by controlling combinations of acceleration of the rotation speed of at least one of the mixed melt 24 and the seed crystal 30 with at least one of deceleration of the rotation speed and constant rotation speed thereof, sequences defining the order of such acceleration, deceleration, and constant speed and respective periods of the acceleration, deceleration, and constant speed, the value of acceleration during the acceleration, the value of deceleration during the deceleration, the maximum rotation speed, the minimum rotation speed, the fluctuation cycle, the rotation direction, and others.

In other words, the plurality of types of patterns have at least one difference in parameters for controlling the relative speed, such as combinations of acceleration of the rotation speed, deceleration of the rotation speed, and constant rotation speed, the above sequences, the value of acceleration during the acceleration, the value of deceleration during the deceleration, the maximum rotation speed, the minimum rotation speed, the fluctuation cycle, the rotation direction, and others, when at least one of the seed crystal 30 and the mixed melt 24 is caused to rotate.

The "repeated fluctuations in accordance with one pattern" means that one cycle of fluctuations in the relative speed specified by a pattern repeats (one cycle of fluctuations in the relative speed) in accordance with the pattern, wherein the pattern is determined in advance or designated by a user. In this case, one cycle of fluctuations in the relative speed indicated by a certain pattern is controlled to repeat periodically in the production apparatus 2.

The "repeated fluctuations in accordance with the plurality of types of patterns" means that one or more cycles of fluctuations in the relative speed indicated by each of the plurality of types of patterns are combined to fluctuate the relative speed, wherein the patterns are determined in advance or designated by a user.

In the present embodiment, the storage unit 35 relates specific information on each of the plurality of types of patterns to the corresponding control information on the rotation speed of at least one of the seed crystal 30 and the mixed melt 24 for realizing each pattern, and stores them in advance. The specific information on each pattern is described as the waveform indicating one cycle of fluctuations in the relative speed over time in the present embodiment, but is not limited to such a form.

In all of the plurality of types of patterns stored in the storage unit 35, the maximum value of the relative speed indicated by each pattern is set to 0.01 m/s or more in advance.

The "maximum value of the relative speed indicated by each pattern is 0.01 m/s or more" specifically means that the maximum value of the relative speed in each cycle of fluctuations in the relative speed indicated by each pattern is 0.01 m/s or more.

A high-quality group 13 nitride crystal can be produced when the maximum value of the relative speed in each pattern is 0.01 m/s or more in the crystal growth step.

The reason that the above effect is produced is not clear, but is supposed as follows. However, the present invention is not limited by the following supposition.

It is supposed that the stagnation of the flow of the mixed melt 24 in the region in contact with the seed crystal 30 in the reaction vessel 52 can be effectively suppressed by rotating at least one of the mixed melt 24 and the seed crystal 30 in the crystal growth step, and repeatedly fluctuating the relative speed between the mixed melt 24 and the seed crystal 30 in the crystal growth step in accordance with one or a plurality of types of predetermined patterns, wherein the maximum value of the relative speed indicated by each pattern is 0.01 m/s or more. Therefore, it is supposed that the amount of inclusions incorporated into the crystal during the crystal growth can be reduced in the present embodiment.

The maximum value of the relative speed indicated by each pattern may be 0.01 m/s or more, more preferably 0.03 m/s or more, or 0.09 m/s or more.

The relative speed is measured according to the following method. Specifically, the relative speed is calculated by applying the values of the physical properties of the mixed melt and the rotation conditions using thermal fluid simulation.

A period T1 with the relative speed satisfying the relationship represented by the following Formula (1) and a period T2 with the relative speed satisfying the relationship represented by the following Formula (2) in each pattern satisfy the relationship represented by the following Formula (3).

$$0 \leq V < 0.01 \tag{1}$$

$$0.01 \leq V \tag{2}$$

$$T1 < T2 \tag{3}$$

In Formulas (1) and (2), V represents the relative speed (m/s).

The "period T1 with the relative speed satisfying the relationship represented by the Formula (1) and the period T2 with the relative speed satisfying the relationship represented by the Formula (2) in each pattern satisfy the relationship represented by the Formula (3)" means that the period T1 with a relative speed of less than 0.01 m/s is longer than the period T2 with a relative speed of 0.01 m/s or more in the crystal growth step.

Accordingly, it is considered that the amount of inclusions incorporated into the crystal during the crystal growth can be further reduced by satisfying the relationship of the Formula (3).

It is preferable that the relationship between the periods T1 and T2 satisfy the relationship represented by the Formula (3). It is more preferable that the period T2 be two times longer, or 10 times longer than the period T1.

In the present embodiment, the period just after starting the rotation of at least one of the mixed melt 24 and the seed crystal 30 is taken as the initial period. After the flow rate of the mixed melt 24 accords with the pattern of the rotation, the period which has the relative speed satisfying the relationship represented by the Formula (1) is taken as the period T1, and the period which has the relative speed satisfying the relationship represented by the Formula (2) is taken as the period T2.

At a certain instant during the period T2 satisfying the relationship represented by the Formula (2) in each pattern, the ratio of a maximum value Vmax to a minimum value Vmin of the relative speed in a main growth surface of the seed crystal 30 in the crystal growth step satisfies the relationship represented by the following Formula (4).

$$Vmax/Vmin < 10 \dots \text{Formula (4)}$$

Specifically, the relative speed in the region with the highest relative speed is referred to as the maximum value Vmax, and the relative speed in the region with the lowest relative speed is referred to as the minimum value Vmin in the entire surface of the main growth surface of the seed crystal 30 at a certain moment (time) during the period T2.

The relative speed in the main growth surface of the seed crystal 30 may change depending on the position in the main growth surface. The maximum value Vmax and the minimum value Vmin of the relative speed in the main growth surface are calculated from a formula on the basis of the viscosity of the mixed melt 24, and the rotation speeds of the mixed melt 24 and the seed crystal 30. This formula may be prepared in advance to calculate the maximum value Vmax and the minimum value Vmin by inputting parameters which affect the relative speed, such as the types or combination of materials contained in the mixed melt 24, and temperature environment. Specifically, the maximum value Vmax and the minimum value Vmin are calculated by thermal fluid simulation.

When the ratio of the maximum value Vmax to the minimum value Vmin of the relative speed in the main growth surface of the seed crystal 30 in the crystal growth step satisfies the relationship represented by the Formula (4) during the period T2, the variations in the relative speed in the main growth surface are small, thereby suppressing generation of parts where the growth rate is locally low. Accordingly, it can be said that a group 13 nitride crystal can be produced having a higher quality.

The value of the maximum value Vmax / the minimum value Vmin is less than 5, or more preferably less than 2.

The rate of change (acceleration or deceleration) in the rotation speed during accelerated rotation or decelerated rotation of at least one of the mixed melt 24 and the seed crystal 30 is preferably 50 rpm/min or more in the crystal growth step.

When the rate of change in the rotation speed is 50 rpm/min or more, the relative speed can be further increased to thereby produce a higher-quality group 13 nitride crystal.

The rate of change in the rotation speed is 300 rpm/min (accelerated to 15 rpm in 3 seconds) or more, more preferably 900 rpm/min (accelerated to 15 rpm in 1 second) or more.

The acceleration and deceleration during the accelerated rotation and decelerated rotation may be calculated by installing well-known measuring devices which measure the rotation speed of each of the seed crystal 30 and the mixed melt 24 in the production apparatus 2, and using the detection results from the measuring devices.

The control unit 34 reads the control information of at least one of the seed crystal 30 and the mixed melt 24 corresponding to the specific information on the plurality of types of patterns stored in the storage unit. The pattern(s) in accordance with which the relative speed is controlled can be changed, for example, by operational direction of a user through an operating unit (not shown).

For example, the control unit 34 allows a display unit (not shown) of the production apparatus 2 to display options of which pattern(s) stored in the storage unit 35 the relative speed is fluctuated in accordance with. When the pattern(s) is/are then selected by the operational direction of a user through the operating unit (not shown), the control unit 34 may control the drive unit 32 according to the control information corresponding to the selected pattern(s).

When a combination of a plurality of types of patterns and an execution order of the patterns are selected by the operational direction of a user through the operating unit, the control unit 34 combines pieces of corresponding control information and controls the drive unit 32 in order to obtain the fluctuations in the relative speed represented by the waveform in which the selected patterns are arranged in the selected execution order. It may be possible to set the number of repetition of each pattern.

Next, the plurality of types of patterns in which the maximum value of the relative speed is 0.01 m/s or more, and the control information on the rotation speed of at least one of the seed crystal 30 and the mixed melt 24 in order to realize each pattern in the production apparatus 2 of the present embodiment will be specifically illustrated as an example.

The control unit 34 may receive revolutions (rpm) per unit time, the rotation speed, the rotation direction, the rotation time, and others (hereafter, may be collectively referred to as rotation control parameters) of the seed crystal 30 and the reaction vessel 52 (mixed melt 24) from well-known measuring devices, and may use them for control. For example, well-known measuring instruments which can measure each of rpm, the rotation speed, the rotation direction, and the rotation time of the seed crystal 30 and the reaction vessel 52 (mixed melt 24) are installed in the mixed melt 24, the drive mechanism of the drive unit 32, or others. These measuring instruments and the control unit 34 are connected to each other to transfer signals. The control unit 34 may receive the measuring results from these measuring instruments to obtain revolutions (rpm) per unit time, the rotation speed, the rotation direction, the rotation time, and others of the seed crystal 30 and the reaction vessel 52 (mixed melt 24), and may use them for control.

The storage unit 35 may relate the pattern(s) to the control information for components of the mixed melt 24 and each combination of environmental parameters such as environmental temperature, and may store them. The control unit 34 then may read the control information corresponding to the pattern(s) designated by a user among the patterns corresponding to components of the mixed melt 24 and the environmental parameters in the crystal growth step, and may execute rotation control.

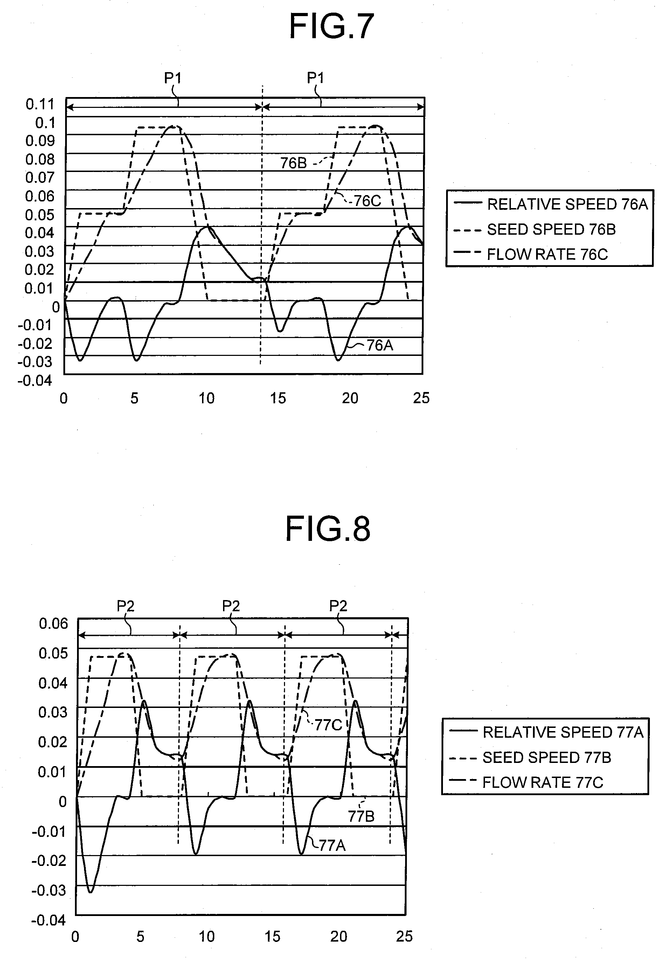

FIGS. 7 to 37 are schematic diagrams illustrating examples of the patterns represented by the waveform indicating the fluctuations in the relative speed in the production apparatus 2 of the present embodiment, and of the control information on the rotation speed of at least one of the seed crystal 30 and the mixed melt 24 for realizing the fluctuations in the relative speed represented by the pattern. FIGS. 7 to 37 are illustrative only and the patterns are not limited to these.

First, FIGS. 7 to 18 will be described. FIGS. 7 to 18 show the cases where the relative speed is repeatedly fluctuated in accordance with the pattern by controlling the rotation of the reaction vessel 52 retaining the seed crystal 30 at the inside bottom. In these cases, for example, in the production apparatus 2A with the configuration illustrated in FIG. 4, the rotation of the seed crystal 30 and the mixed melt 24 is controlled by controlling the rotation of the reaction vessel 52 retaining the seed crystal 30 and the mixed melt 24. In the descriptions of FIGS. 7 to 18, the cases where the rotation is controlled using the production apparatus 2A will be described.

In the example illustrated in FIG. 7, the control unit 34 reads from the storage unit 35 the control information corresponding to the pattern specified by the waveform indicated by a part of a line 76A in each cycle P1 illustrated in FIG. 7. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and then held for 3 seconds, accelerated to 30 rpm in 1 second, held for 3 seconds, decelerated for 2 seconds, and stopped for 3 seconds." The control unit 34 controls the rotation of the reaction vessel 52 according to the read control information. This control causes the seed crystal 30 to show the fluctuations in the rotation speed indicated by a line 76B in FIG. 7 (see "Seed speed" in the figure; the same applies hereinafter). The fluctuations in the rotation speed of the reaction vessel 52 cause the mixed melt 24 to show the fluctuations in the flow rate (rotation speed) indicated by a line 76C in FIG. 7 (see "Flow rate" in the figure; the same applies hereinafter). As a result, the rotation of the reaction vessel 52 realizes the fluctuations in the relative speed of the pattern indicated by the line 76A.

In the example illustrated in FIG. 8, the control unit 34 reads from the storage unit 35 the control information corresponding to the pattern specified by the waveform indicated by a part of a line 77A in each cycle P2 illustrated in FIG. 8. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 3 seconds." The control unit 34 controls the rotation of the reaction vessel 52 according to the read control information. This control causes the seed crystal 30 to show the fluctuations in the rotation speed indicated by a line 77B in FIG. 8. The fluctuations in the rotation speed of the reaction vessel 52 cause the mixed melt 24 to show the fluctuations in the flow rate (rotation speed) indicated by a line 77C in FIG. 8. As a result, the rotation of the reaction vessel 52 realizes the fluctuations in the relative speed of the pattern indicated by the line 77A.

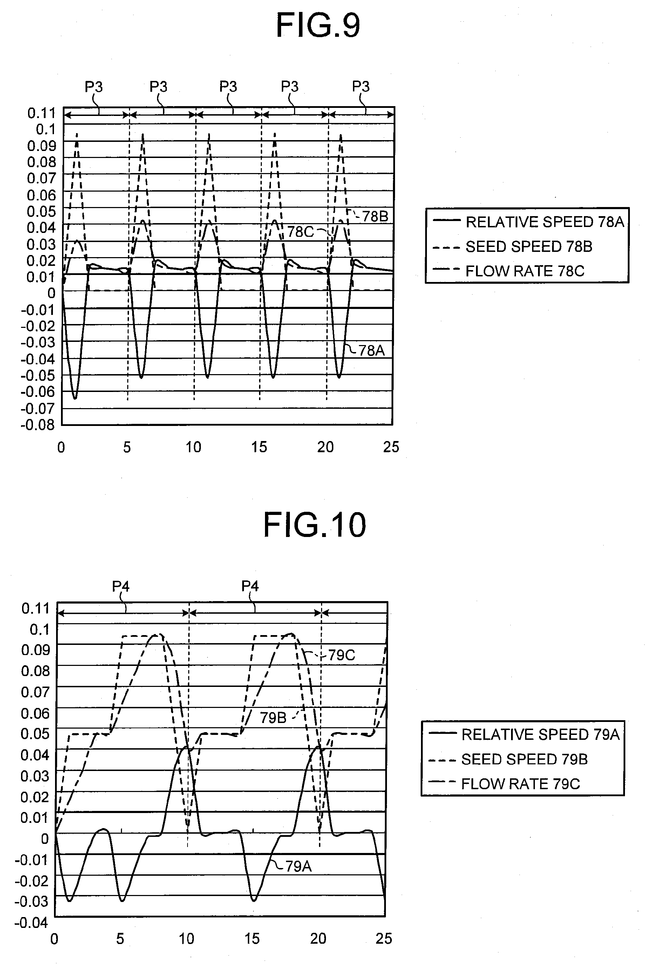

In the example illustrated in FIG. 9, the control unit 34 reads from the storage unit 35 the control information corresponding to the pattern specified by the waveform indicated by a part of a line 78A in each cycle P3 illustrated in FIG. 9. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 3 seconds." The control unit 34 controls the rotation of the reaction vessel 52 according to the read control information. This control causes the seed crystal 30 to show the fluctuations in the rotation speed indicated by a line 78B in FIG. 9. The fluctuations in the rotation speed of the reaction vessel 52 cause the mixed melt 24 to show the fluctuations in the flow rate (rotation speed) indicated by a line 78C in FIG. 9. As a result, the rotation of the reaction vessel 52 realizes the fluctuations in the relative speed of the pattern indicated by the line 78A.

In the example illustrated in FIG. 10, the control unit 34 reads from the storage unit 35 the control information corresponding to the pattern specified by the waveform indicated by a part of a line 79A in each cycle P4 illustrated in FIG. 10. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and held for 3 seconds; and the rotation of the reaction vessel 52 is accelerated to 30 rpm in 1 second, held for 3 seconds, decelerated for 2 seconds, and stopped for 0 seconds." The control unit 34 controls the rotation of the reaction vessel 52 according to the read control information. This control causes the seed crystal 30 to show the fluctuations in the rotation speed indicated by a line 79B in FIG. 10. The fluctuations in the rotation speed of the reaction vessel 52 cause the mixed melt 24 to show the fluctuations in the flow rate (rotation speed) indicated by a line 79C in FIG. 10. As a result, the rotation of the reaction vessel 52 realizes the fluctuations in the relative speed of the pattern indicated by the line 79A.

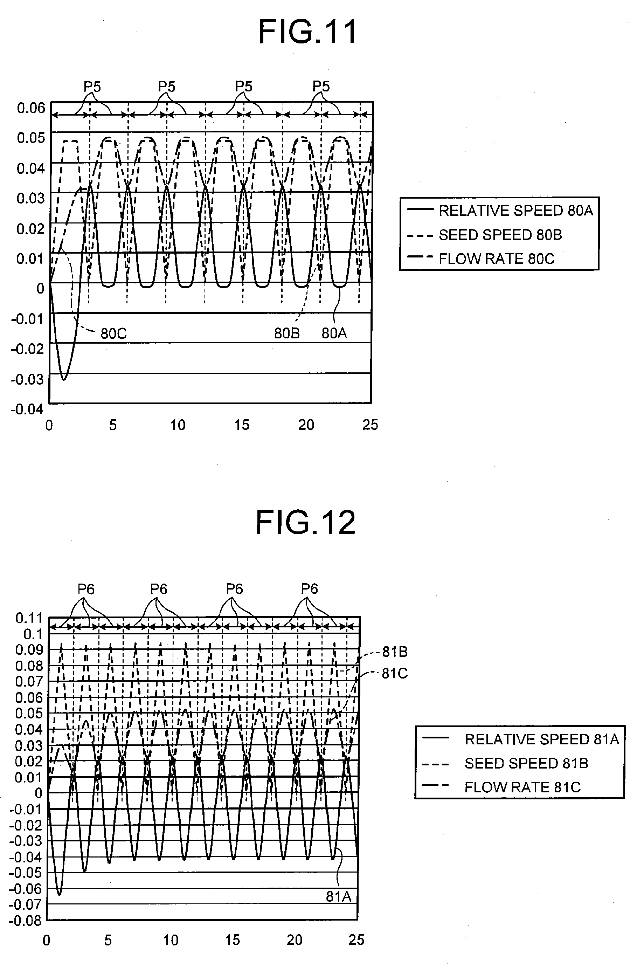

In the example illustrated in FIG. 11, the control unit 34 reads from the storage unit 35 the control information corresponding to the pattern specified by the waveform indicated by a part of a line 80A in each cycle P5 illustrated in FIG. 11. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 0 seconds." The control unit 34 controls the rotation of the reaction vessel 52 according to the read control information. This control causes the seed crystal 30 to show the fluctuations in the rotation speed indicated by a line 80B in FIG. 11. The fluctuations in the rotation speed of the reaction vessel 52 cause the mixed melt 24 to show the fluctuations in the flow rate (rotation speed) indicated by a line 80C in FIG. 11. As a result, the rotation of the reaction vessel 52 realizes the fluctuations in the relative speed of the pattern indicated by the line 80A.

In the example illustrated in FIG. 12, the control unit 34 reads from the storage unit 35 the control information corresponding to the pattern specified by the waveform indicated by a part of a line 81A (except for the first four cycles of the waveform as the initial waveform) in each cycle P6 illustrated in FIG. 12. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 0 seconds." The control unit 34 controls the rotation of the reaction vessel 52 according to the read control information. This control causes the seed crystal 30 to show the fluctuations in the rotation speed indicated by a line 81B in FIG. 12. The fluctuations in the rotation speed of the reaction vessel 52 cause the mixed melt 24 to show the fluctuations in the flow rate (rotation speed) indicated by a line 81C in FIG. 12. As a result, the rotation of the reaction vessel 52 realizes the fluctuations in the relative speed of the pattern indicated by the line 81A.

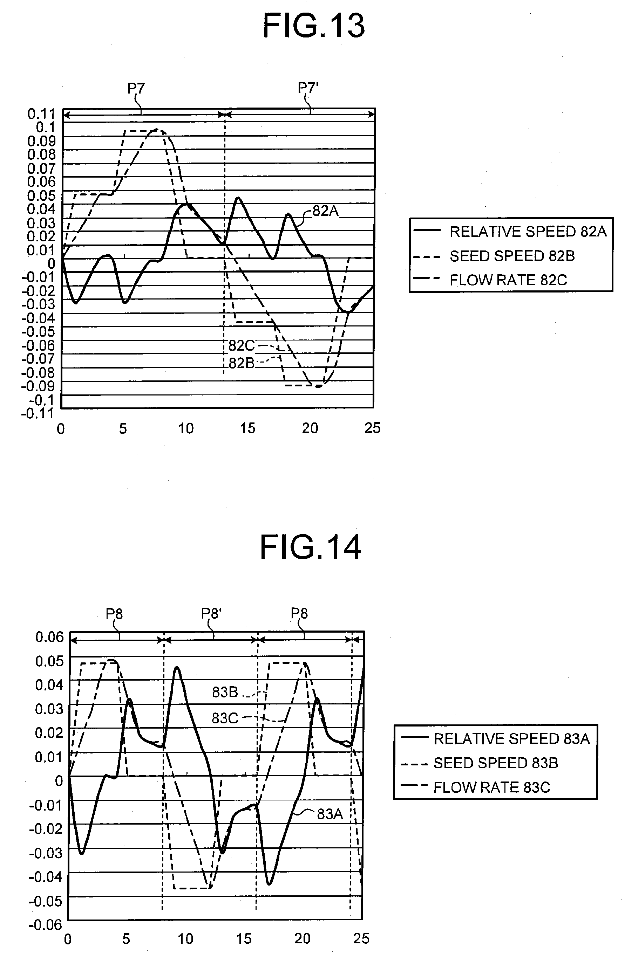

In the example illustrated in FIG. 13, the control unit 34 reads from the storage unit 35 the control information corresponding to the pattern specified by the waveform indicated by parts of a line 82A in cycles P7 and P7' illustrated in FIG. 13. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, accelerated to 30 rpm in 1 second, held for 3 seconds, decelerated for 2 seconds, and stopped for 3 seconds; and the same sequence is carried out in the reverse rotation direction." The control unit 34 controls the rotation of the reaction vessel 52 according to the read control information. This control causes the seed crystal 30 to show the fluctuations in the rotation speed indicated by a line 82B in FIG. 13. The fluctuations in the rotation speed of the reaction vessel 52 cause the mixed melt 24 to show the fluctuations in the flow rate (rotation speed) indicated by a line 82C in FIG. 13. As a result, the rotation of the reaction vessel 52 realizes the fluctuations in the relative speed of the pattern indicated by the line 82A.

In the example illustrated in FIG. 14, the control unit 34 reads from the storage unit 35 the control information corresponding to the pattern specified by the waveform indicated by parts of a line 83A in cycles P8 and P8' illustrated in FIG. 14. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 3 seconds; and the same sequence is carried out in the reverse rotation direction." The control unit 34 controls the rotation of the reaction vessel 52 according to the read control information. This control causes the seed crystal 30 to show the fluctuations in the rotation speed indicated by a line 83B in FIG. 14. The fluctuations in the rotation speed of the reaction vessel 52 cause the mixed melt 24 to show the fluctuations in the flow rate (rotation speed) indicated by a line 83C in FIG. 14. As a result, the rotation of the reaction vessel 52 realizes the fluctuations in the relative speed of the pattern indicated by the line 83A.

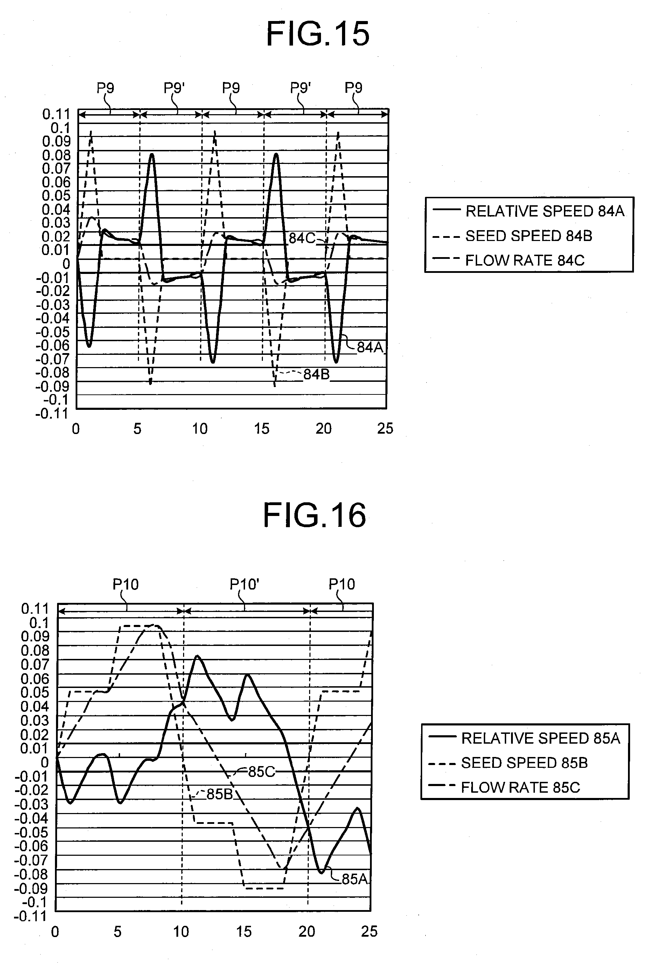

In the example illustrated in FIG. 15, the control unit 34 reads from the storage unit 35 the control information corresponding to the pattern specified by the waveform indicated by parts of a line 84A in cycles P9 and P9' illustrated in FIG. 15. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 3 seconds; and the same sequence is carried out in the reverse rotation direction." The control unit 34 controls the rotation of the reaction vessel 52 according to the read control information. This control causes the seed crystal 30 to show the fluctuations in the rotation speed indicated by a line 84B in FIG. 15. The fluctuations in the rotation speed of the reaction vessel 52 cause the mixed melt 24 to show the fluctuations in the flow rate (rotation speed) indicated by a line 84C in FIG. 15. As a result, the rotation of the reaction vessel 52 realizes the fluctuations in the relative speed of the pattern indicated by the line 84A.

In the example illustrated in FIG. 16, the control unit 34 reads from the storage unit 35 the control information corresponding to the pattern specified by the waveform indicated by parts of a line 85A in cycles P10 and P10' illustrated in FIG. 16. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and held for 3 seconds; the rotation of the reaction vessel 52 is accelerated to 30 rpm in 1 second, held for 3 seconds, decelerated for 2 seconds, and stopped for 0 seconds; and the same sequence is carried out in the reverse rotation direction." The control unit 34 controls the rotation of the reaction vessel 52 according to the read control information. This control causes the seed crystal 30 to show the fluctuations in the rotation speed indicated by a line 85B in FIG. 16. The fluctuations in the rotation speed of the reaction vessel 52 cause the mixed melt 24 to show the fluctuations in the flow rate (rotation speed) indicated by a line 85C in FIG. 16. As a result, the rotation of the reaction vessel 52 realizes the fluctuations in the relative speed of the pattern indicated by the line 85A.

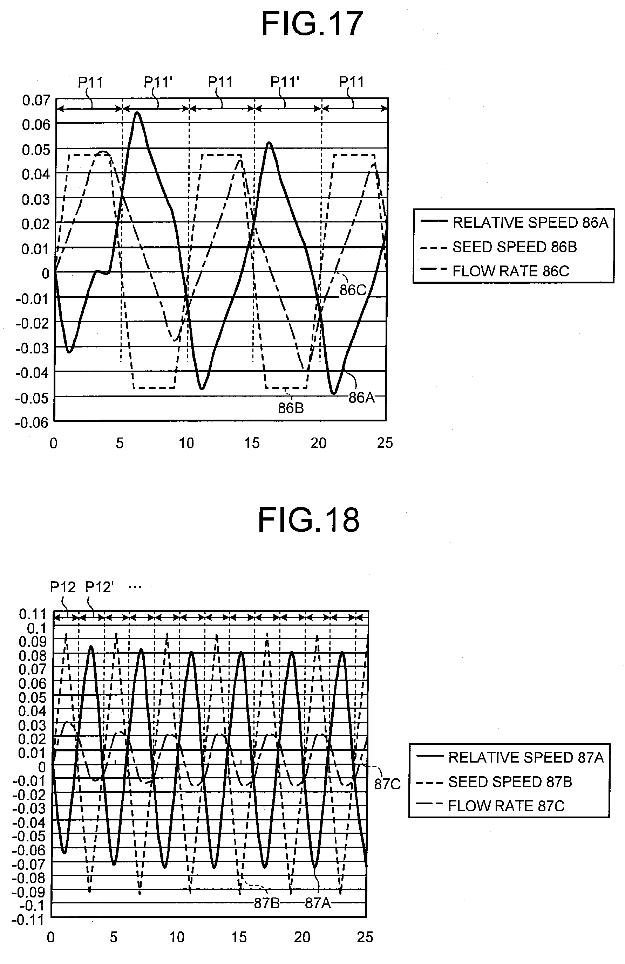

In the example illustrated in FIG. 17, the control unit 34 reads from the storage unit 35 the control information corresponding to the pattern specified by the waveform indicated by parts of a line 86A in cycles P11 and P11' illustrated in FIG. 17. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 0 seconds; and the same sequence is carried out in the reverse rotation direction." The control unit 34 controls the rotation of the reaction vessel 52 according to the read control information. This control causes the seed crystal 30 to show the fluctuations in the rotation speed indicated by a line 86B in FIG. 17. The fluctuations in the rotation speed of the reaction vessel 52 cause the mixed melt 24 to show the fluctuations in the flow rate (rotation speed) indicated by a line 86C in FIG. 17. As a result, the rotation of the reaction vessel 52 realizes the fluctuations in the relative speed of the pattern indicated by the line 86A.

In the example illustrated in FIG. 18, the control unit 34 reads from the storage unit 35 the control information corresponding to the pattern specified by the waveform indicated by parts of a line 87A in cycles P12 and P12' illustrated in FIG. 18. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 0 seconds; and the same sequence is carried out in the reverse rotation direction." The control unit 34 controls the rotation of the reaction vessel 52 according to the read control information. This control causes the seed crystal 30 to show the fluctuations in the rotation speed indicated by a line 87B in FIG. 18. The fluctuations in the rotation speed of the reaction vessel 52 cause the mixed melt 24 to show the fluctuations in the flow rate (rotation speed) indicated by a line 87C in FIG. 18. As a result, the rotation of the reaction vessel 52 realizes the fluctuations in the relative speed of the pattern indicated by the line 87A.

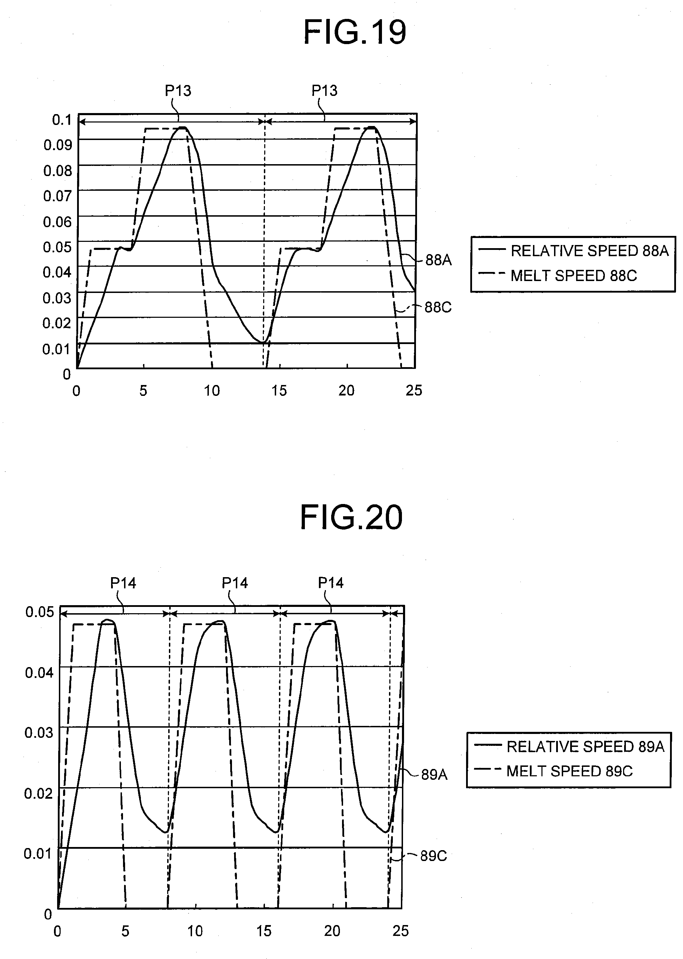

Next, FIGS. 19 to 30 will be described. FIGS. 19 to 30 illustrate the cases where the relative speed is repeatedly fluctuated in accordance with the pattern by controlling the rotation of the mixed melt 24 without controlling the rotation of the seed crystal 30. In these cases, for example, in the production apparatus 2B with the configuration illustrated in FIG. 5, the rotation of the mixed melt 24 is controlled by controlling the rotation of the reaction vessel 52. In the production apparatus 2C with the configuration illustrated in FIG. 6, only the rotation of the mixed melt 24 is controlled by controlling the rotation of a stirrer 40B.

In FIGS. 19 to 30, the cases where the rotation of the mixed melt 24 is controlled by controlling the rotation of the reaction vessel 52 will be described using the production apparatus 2B illustrated in FIG. 5.

In the example illustrated in FIG. 19, the control unit 34 reads from the storage unit 35 the control information corresponding to the pattern specified by the waveform indicated by a part of a line 88A in each cycle P13 illustrated in FIG. 19. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and then held for 3 seconds, accelerated to 30 rpm in 1 second, held for 3 seconds, decelerated for 2 seconds, and stopped for 3 seconds." The control unit 34 controls the rotation of the reaction vessel 52 according to the read control information. This control causes the mixed melt 24 to show the fluctuations in the rotation speed indicated by a line 88C in FIG. 19 (see "Melt speed" in the figure; the same applies hereinafter). As a result, the rotation of the mixed melt 24 realizes the fluctuations in the relative speed of the pattern indicated by the line 88A.

In the example illustrated in FIG. 20, the control unit 34 reads from the storage unit 35 the control information corresponding to the pattern specified by the waveform indicated by a part of a line 89A in each cycle P14 illustrated in FIG. 20. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 3 seconds." The control unit 34 controls the rotation of the reaction vessel 52 according to the read control information. This control causes the mixed melt 24 to show the fluctuations in the melt speed (rotation speed) indicated by a line 89C in FIG. 20. As a result, the rotation of the mixed melt 24 realizes the fluctuations in the relative speed of the pattern indicated by the line 89A.

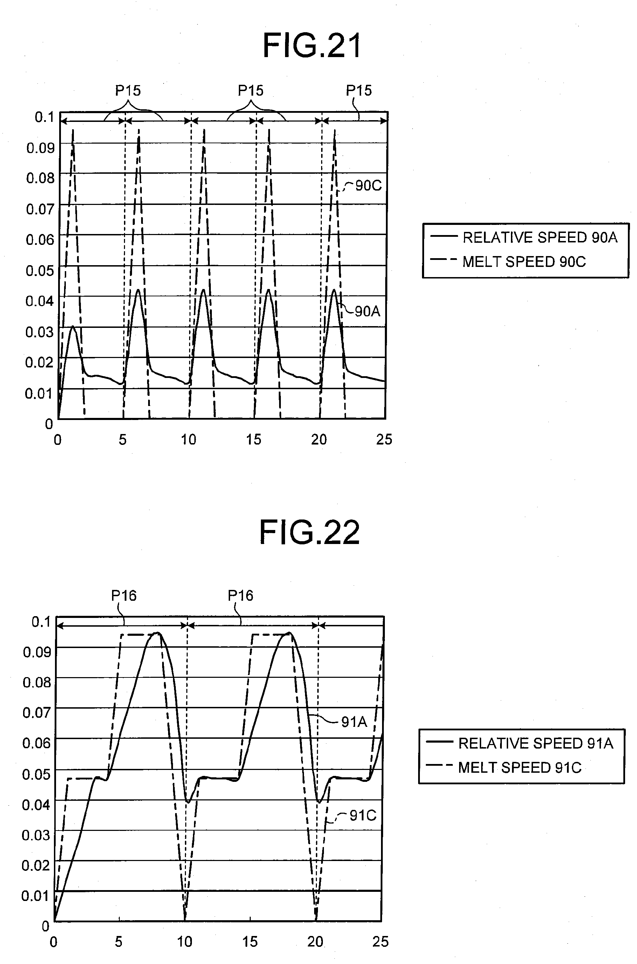

In the example illustrated in FIG. 21, the control unit 34 reads from the storage unit 35 the control information corresponding to the pattern specified by the waveform indicated by a part of a line 90A in each cycle P15 illustrated in FIG. 21. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 3 seconds." The control unit 34 controls the rotation of the reaction vessel 52 according to the read control information. This control causes the mixed melt 24 to show the fluctuations in the melt speed (rotation speed) indicated by a line 90C in FIG. 21. As a result, the rotation of the mixed melt 24 realizes the fluctuations in the relative speed of the pattern indicated by the line 90A.

In the example illustrated in FIG. 22, the control unit 34 reads from the storage unit 35 the control information corresponding to the pattern specified by the waveform indicated by a part of a line 91A in each cycle P16 illustrated in FIG. 22. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and held for 3 seconds; and the rotation of the reaction vessel 52 is accelerated to 30 rpm in 1 second, held for 3 seconds, decelerated for 2 seconds, and stopped for 0 seconds." The control unit 34 controls the rotation of the reaction vessel 52 according to the read control information. This control causes the mixed melt 24 to show the fluctuations in the melt speed (rotation speed) indicated by a line 91C in FIG. 22. As a result, the rotation of the mixed melt 24 realizes the fluctuations in the relative speed of the pattern indicated by the line 91A.

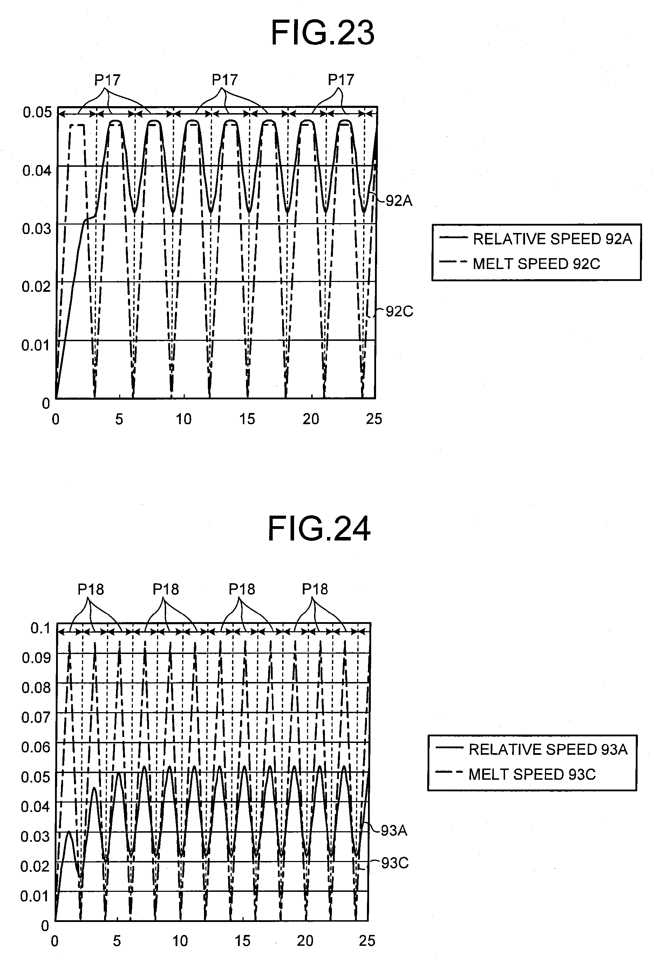

In the example illustrated in FIG. 23, the control unit 34 reads from the storage unit 35 the control information corresponding to the pattern specified by the waveform indicated by a part of a line 92A in each cycle P17 illustrated in FIG. 23. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 0 seconds." The control unit 34 controls the rotation of the reaction vessel 52 according to the read control information. This control causes the mixed melt 24 to show the fluctuations in the melt speed (rotation speed) indicated by a line 92C in FIG. 23. As a result, the rotation of the mixed melt 24 realizes the fluctuations in the relative speed of the pattern indicated by the line 92A.

In the example illustrated in FIG. 24, the control unit 34 reads from the storage unit 35 the control information corresponding to the pattern specified by the waveform indicated by a part of a line 93A (except for the first four cycles of the waveform as the initial waveform) in each cycle P18 illustrated in FIG. 24. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 0 seconds." The control unit 34 controls the rotation of the reaction vessel 52 according to the read control information. This control causes the mixed melt 24 to show the fluctuations in the melt speed (rotation speed) indicated by a line 93C in FIG. 24. As a result, the rotation of the mixed melt 24 realizes the fluctuations in the relative speed of the pattern indicated by the line 93A.

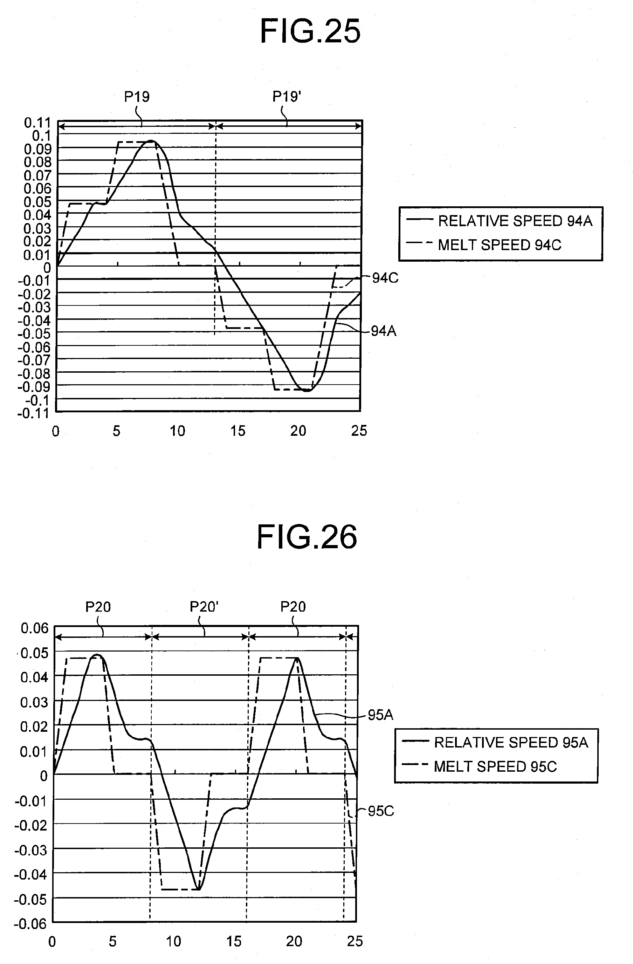

In the example illustrated in FIG. 25, the control unit 34 reads from the storage unit 35 the control information corresponding to the pattern specified by the waveform indicated by parts of a line 94A in cycles P19 and P19' illustrated in FIG. 25. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and held for 3 seconds; the rotation of the reaction vessel 52 is accelerated to 30 rpm in 1 second, held for 3 seconds, decelerated for 2 seconds, and stopped for 3 seconds; and the same sequence is carried out in the reverse rotation direction." The control unit 34 controls the rotation of the reaction vessel 52 according to the read control information. This control causes the mixed melt 24 to show the fluctuations in the melt speed (rotation speed) indicated by a line 94C in FIG. 25. As a result, the rotation of the mixed melt 24 realizes the fluctuations in the relative speed of the pattern indicated by the line 94A.

In the example illustrated in FIG. 26, the control unit 34 reads from the storage unit 35 the control information corresponding to the pattern specified by the waveform indicated by parts of a line 95A in cycles P20 and P20' illustrated in FIG. 26. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 3 seconds; and the same sequence is carried out in the reverse rotation direction." The control unit 34 controls the rotation of the reaction vessel 52 according to the read control information. This control causes the mixed melt 24 to show the fluctuations in the melt speed (rotation speed) indicated by a line 95C in FIG. 26. As a result, the rotation of the mixed melt 24 realizes the fluctuations in the relative speed of the pattern indicated by the line 95A.

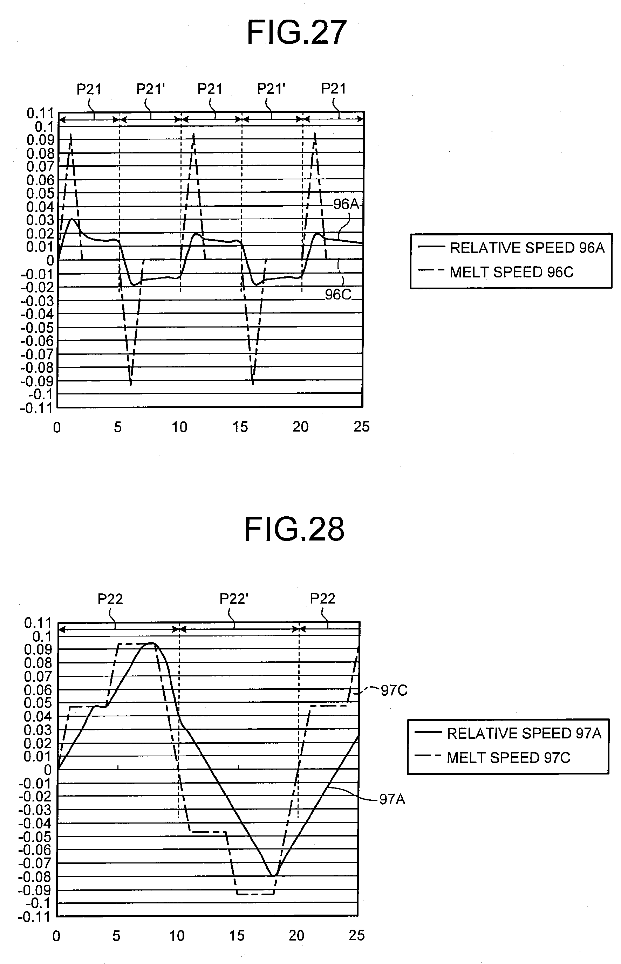

In the example illustrated in FIG. 27, the control unit 34 reads from the storage unit 35 the control information corresponding to the pattern specified by the waveform indicated by parts of a line 96A in cycles P21 and P21' illustrated in FIG. 27. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 3 seconds; and the same sequence is carried out in the reverse rotation direction." The control unit 34 controls the rotation of the reaction vessel 52 according to the read control information. This control causes the mixed melt 24 to show the fluctuations in the melt speed (rotation speed) indicated by a line 96C in FIG. 27. As a result, the rotation of the mixed melt 24 realizes the fluctuations in the relative speed of the pattern indicated by the line 96A.

In the example illustrated in FIG. 28, the control unit 34 reads from the storage unit 35 the control information corresponding to the pattern specified by the waveform indicated by parts of a line 97A in cycles P22 and P22' illustrated in FIG. 28. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second and held for 3 seconds; the rotation of the reaction vessel 52 is accelerated to 30 rpm in 1 second, held for 3 seconds, decelerated for 2 seconds, and stopped for 0 seconds; and the same sequence is carried out in the reverse rotation direction." The control unit 34 controls the rotation of the reaction vessel 52 according to the read control information. This control causes the mixed melt 24 to show the fluctuations in the melt speed (rotation speed) indicated by a line 97C in FIG. 28. As a result, the rotation of the mixed melt 24 realizes the fluctuations in the relative speed of the pattern indicated by the line 97A.

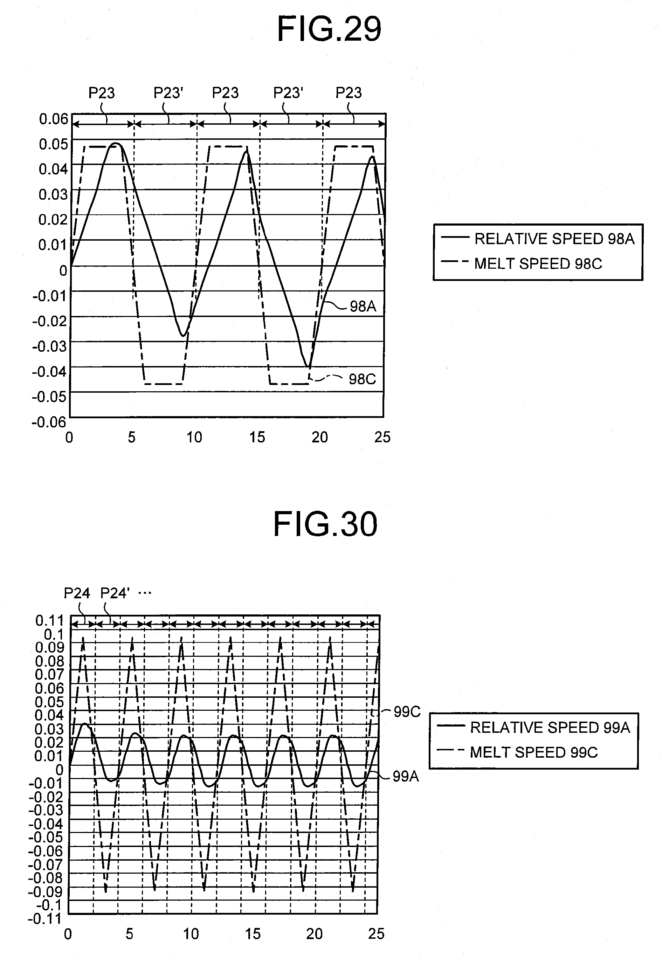

In the example illustrated in FIG. 29, the control unit 34 reads from the storage unit 35 the control information corresponding to the pattern specified by the waveform indicated by parts of a line 98A in cycles P23 and P23' illustrated in FIG. 29. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 3 seconds, decelerated for 1 second, and stopped for 0 seconds; and the same sequence is carried out in the reverse rotation direction." The control unit 34 controls the rotation of the reaction vessel 52 according to the read control information. This control causes the mixed melt 24 to show the fluctuations in the melt speed (rotation speed) indicated by a line 98C in FIG. 29. As a result, the rotation of the mixed melt 24 realizes the fluctuations in the relative speed of the pattern indicated by the line 98A.

In the example illustrated in FIG. 30, the control unit 34 reads from the storage unit 35 the control information corresponding to the pattern specified by the waveform indicated by parts of a line 99A in cycles P24 and P24' illustrated in FIG. 30. Specifically, the control unit 34 reads as the control information on the rotation speed of the reaction vessel 52 for realizing this pattern, for example, the information which indicates "the following is repeated: the rotation of the reaction vessel 52 is accelerated to 15 rpm in 1 second, held for 0 seconds, decelerated for 1 second, and stopped for 0 seconds; and the same sequence is carried out in the reverse rotation direction." The control unit 34 controls the rotation of the reaction vessel 52 according to the read control information. This control causes the mixed melt 24 to show the fluctuations in the melt speed (rotation speed) indicated by a line 99C in FIG. 30. As a result, the rotation of the mixed melt 24 realizes the fluctuations in the relative speed of the pattern indicated by the line 99A.

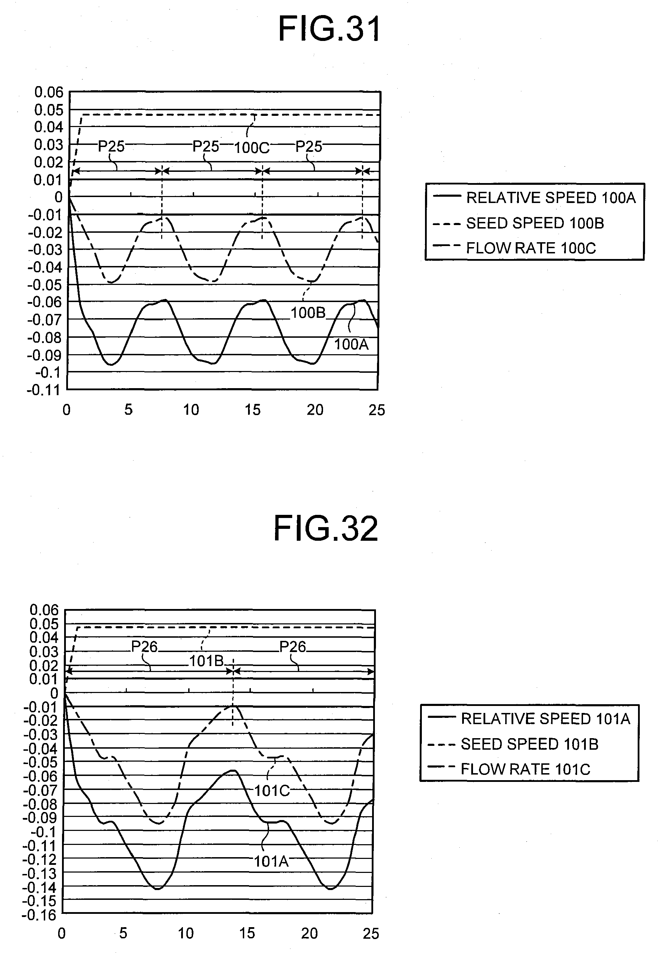

Next, FIGS. 31 to 37 will be described.

In FIGS. 31 to 37, the cases where the reaction vessel 52 and the seed crystal 30 are rotated in opposite directions (reverse rotation) and each the rotation speed of them is controlled to control the relative speed of the mixed melt 24 will be described.

In the example illustrated in FIG. 31, the control unit 34 reads from the storage unit 35 the control information corresponding to the pattern specified by the waveform indicated by a part of a line 100A in each cycle P25 illustrated in FIG. 31. Specifically, the control unit 34 reads as the control information on the rotation speed of the seed crystal 30 for realizing this pattern, for example, the control information which indicates "the rotation of the seed crystal 30 is accelerated to 15 rpm in 1 second and then held." The control unit 34 reads as the control information of the mixed melt 24, i.e., the reaction vessel 52, and the like for realizing this pattern, for example, the control information which indicates "the following is repeated: the rotation of the reaction vessel 52 is accelerated to 15 rpm in 1 second in the direction opposite to the rotation direction of the seed crystal 30, held for 3 seconds, decelerated for 1 second, and stopped for 3 seconds." The control unit 34 controls the rotation of each of the reaction vessel 52 and the seed crystal 30 according to the read control information. This control causes the seed crystal 30 to show the fluctuations in the rotation speed (Seed speed) indicated by a line 100B in FIG. 31. This control causes the mixed melt 24 to show the fluctuations in the rotation speed (flow rate) indicated by a line 100C in FIG. 31. As a result, the rotation of the seed crystal 30 and the mixed melt 24 realizes the fluctuations in the relative speed of the pattern indicated by the line 100A.

In the example illustrated in FIG. 32, the control unit 34 reads from the storage unit 35 the control information corresponding to the pattern specified by the waveform indicated by a part of a line 101A in each cycle P26 illustrated in FIG. 32. Specifically, the control unit 34 reads as the control information on the rotation speed of the seed crystal 30 for realizing this pattern, for example, the control information which indicates "the rotation of the seed crystal 30 is accelerated to 15 rpm in 1 second and then held." The control unit 34 reads as the control information of the mixed melt 24, i.e., the reaction vessel 52, and the like for realizing this pattern, for example, the control information which indicates "the following is repeated: the rotation of the reaction vessel 52 is accelerated to 15 rpm in 1 second in the direction opposite to the rotation of the seed crystal 30, held for 3 seconds, accelerated to 30 rpm in 1 second, held for 3 seconds, decelerated for 2 seconds, and stopped for 3 seconds." The control unit 34 controls the rotation of each of the reaction vessel 52 and the seed crystal 30 according to the read control information. This control causes the seed crystal 30 to show the fluctuations in the rotation speed (Seed speed) indicated by a line 101B in FIG. 32. This control causes the mixed melt 24 to show the fluctuations in the rotation speed (flow rate) indicated by a line 101C in FIG. 32. As a result, the rotation of the seed crystal 30 and the mixed melt 24 realizes the fluctuations in the relative speed of the pattern indicated by the line 101A.

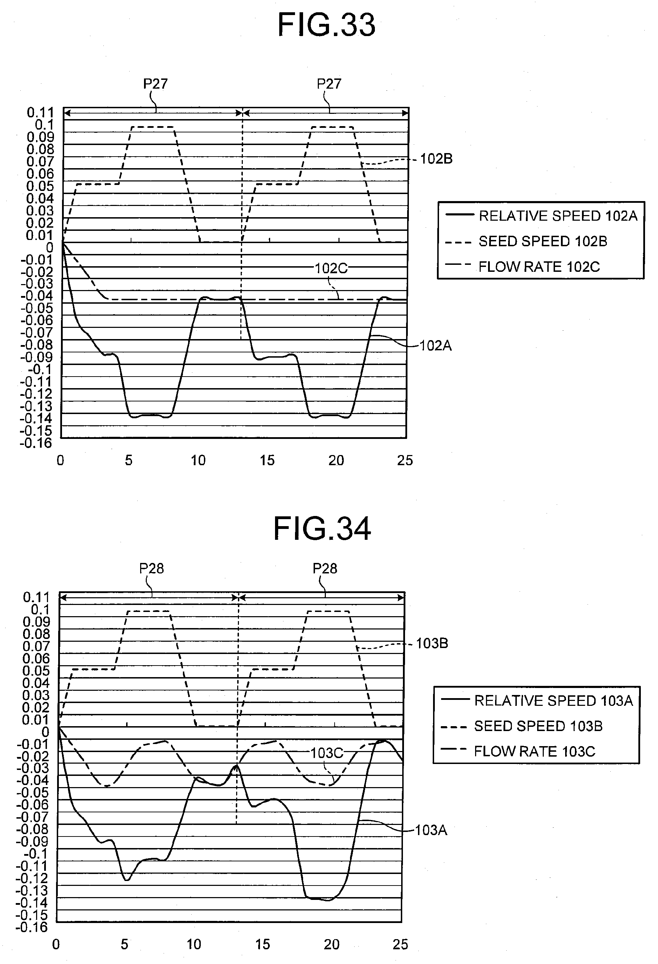

In the example illustrated in FIG. 33, the control unit 34 reads from the storage unit 35 the control information corresponding to the pattern specified by the waveform indicated by a part of a line 102A in each cycle P27 illustrated in FIG. 33. Specifically, the control unit 34 reads as the control information on the rotation speed of the seed crystal 30 for realizing this pattern, for example, the control information which indicates "the following is repeated: the rotation of the seed crystal 30 is accelerated to 15 rpm in 1 second and held for 3 seconds; and the rotation of the seed crystal 30 is accelerated to 30 rpm in 1 second, held for 3 seconds, decelerated for 2 seconds, and stopped for 3 seconds." The control unit 34 reads as the control information of the mixed melt 24, i.e., the reaction vessel 52, and the like for realizing this pattern, for example, the control information which indicates "the rotation of the reaction vessel 52 is accelerated to 15 rpm in 1 second in the direction opposite to the rotation of the seed crystal 30 and then held." The control unit 34 controls the rotation of each of the reaction vessel 52 and the seed crystal 30 according to the read control information. This control causes the seed crystal 30 to show the fluctuations in the rotation speed (Seed speed) indicated by a line 102B in FIG. 33. This control causes the mixed melt 24 to show the fluctuations in the rotation speed (flow rate) indicated by a line 102C in FIG. 33. As a result, the rotation of the seed crystal 30 and the mixed melt 24 realizes the fluctuations in the relative speed of the pattern indicated by the line 102A.

In the example illustrated in FIG. 34, the control unit 34 reads from the storage unit 35 the control information corresponding to the pattern specified by the waveform indicated by a part of a line 103A in each cycle P28 illustrated in FIG. 34. Specifically, the control unit 34 reads as the control information on the rotation speed of the seed crystal 30 for realizing this pattern, for example, the control information which indicates "the following is repeated: the rotation of the seed crystal 30 is accelerated to 15 rpm in 1 second and held for 3 seconds; and the rotation of the seed crystal 30 is accelerated to 30 rpm in 1 second, held for 3 seconds, decelerated for 2 seconds, and stopped for 3 seconds." The control unit 34 reads as the control information of the mixed melt 24, i.e., the reaction vessel 52, and the like for realizing this pattern, for example, the control information which indicates "the following is repeated: the rotation of the reaction vessel 52 is accelerated to 15 rpm in 1 second in the direction opposite to the rotation of the seed crystal 30, held for 3 seconds, decelerated for 1 second, and stopped for 3 seconds." The control unit 34 controls the rotation of each of the reaction vessel 52 and the seed crystal 30 according to the read control information. This control causes the seed crystal 30 to periodically repeat the fluctuations in the rotation speed (Seed speed) indicated by a line 103B in FIG. 34 (see P28 in FIG. 34). This control causes the mixed melt 24 to periodically repeat the fluctuations in the rotation speed (flow rate) indicated by a line 103C in FIG. 34 (see P28 in FIG. 34). As a result, the rotation of the seed crystal 30 and the mixed melt 24 realizes the fluctuations in the relative speed of the pattern indicated by the line 103A.

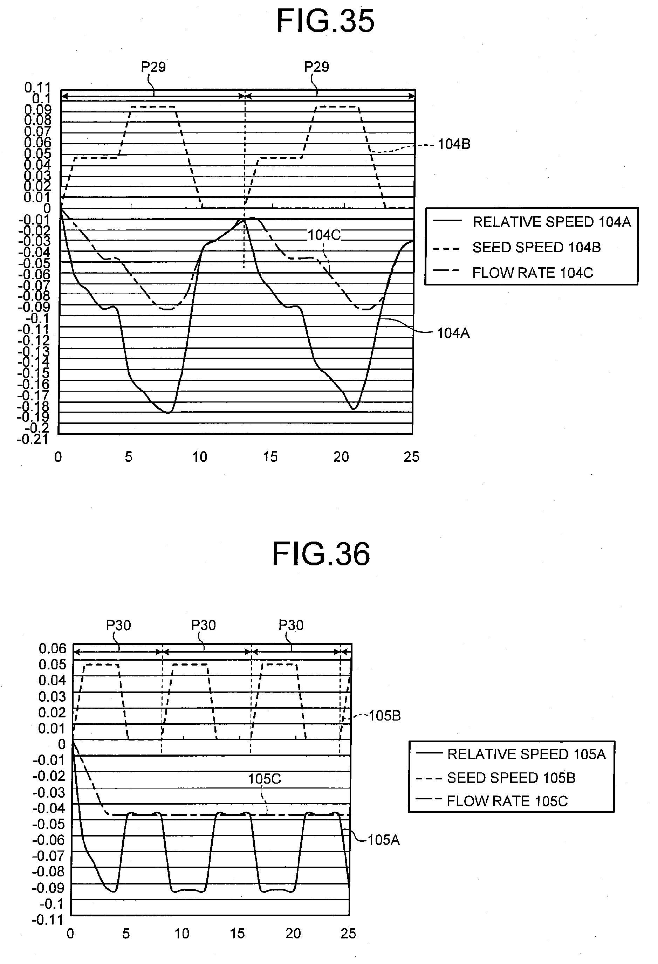

In the example illustrated in FIG. 35, the control unit 34 reads from the storage unit 35 the control information corresponding to the pattern specified by the waveform indicated by a part of a line 104A in each cycle P29 illustrated in FIG. 35. Specifically, the control unit 34 reads as the control information on the rotation speed of the seed crystal 30 for realizing this pattern, for example, the control information which indicates "the following is repeated: the rotation of the seed crystal 30 is accelerated to 15 rpm in 1 second and held for 3 seconds; and the rotation of the seed crystal 30 is accelerated to 30 rpm in 1 second, held for 3 seconds, decelerated for 2 seconds, and stopped for 3 seconds." The control unit 34 reads as the control information of the mixed melt 24, i.e., the reaction vessel 52, and the like for realizing this pattern, for example, the control information which indicates "the following is repeated: the rotation of the reaction vessel 52 is accelerated to 15 rpm in 1 second in the direction opposite to the rotation of the seed crystal 30 and held for 3 seconds; and the rotation of the reaction vessel 52 is accelerated to 30 rpm in 1 second, held for 3 seconds, decelerated for 2 seconds, and stopped for 3 seconds." The control unit 34 controls the rotation of each of the reaction vessel 52 and the seed crystal 30 according to the read control information. This control causes the seed crystal 30 to repeat the fluctuations in the rotation speed (Seed speed) indicated by a line 104B in FIG. 35. This control causes the mixed melt 24 to repeat the fluctuations in the rotation speed (flow rate) indicated by a line 104C in FIG. 35. As a result, the rotation of the seed crystal 30 and the mixed melt 24 realizes the fluctuations in the relative speed of the pattern indicated by the line 104A.

In the example illustrated in FIG. 36, the control unit 34 reads from the storage unit 35 the control information corresponding to the pattern specified by the waveform indicated by a part of a line 105A in each cycle P30 illustrated in FIG. 36. Specifically, the control unit 34 reads as the control information on the rotation speed of the seed crystal 30 for realizing this pattern, for example, the control information which indicates "the following is repeated: the rotation of the seed crystal 30 is accelerated to 15 rpm in 1 second, held for 3 seconds, decelerated for 1 second, and stopped for 3 seconds." The control unit 34 reads as the control information of the mixed melt 24, i.e., the reaction vessel 52, and the like for realizing this pattern, for example, the control information which indicates "the rotation of the reaction vessel

EP 2 787 104 B1

52 is accelerated to 15 rpm in 1 second in the direction opposite to the rotation of the seed crystal 30 and then held." The control unit 34 controls the rotation of each of the reaction vessel 52 and the seed crystal 30 according to the read control information. This control causes the seed crystal 30 to repeat the fluctuations in the rotation speed (seed speed) indicated by a line 105B in FIG. 36. This control causes the mixed melt 24 to repeat the fluctuations in the rotation speed (flow rate) indicated by a line 105C in FIG. 36. As a result, the rotation of the seed crystal 30 and the mixed melt 24 realizes the fluctuations in the relative speed of the pattern indicated by the line 105A.

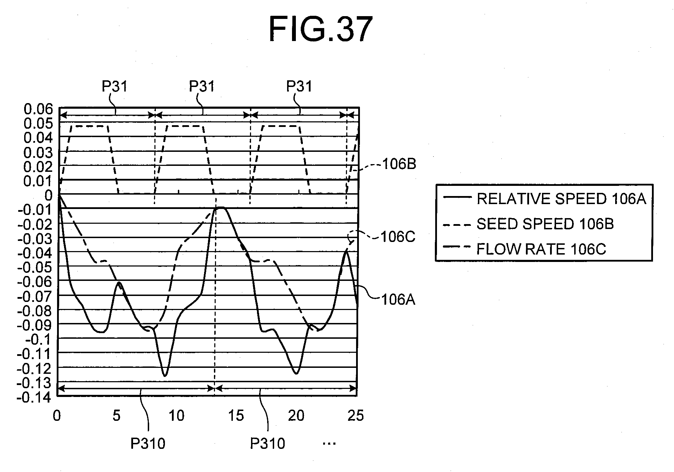

In the example illustrated in FIG. 37, the control unit 34 reads from the storage unit 35 the control information corresponding to the pattern specified by the waveform indicated by a part of a line 106A in each cycle P310 illustrated in FIG. 37. Specifically, the control unit 34 reads as the control information on the rotation speed of the seed crystal 30 for realizing this pattern, for example, the control information which indicates "the following is repeated: the rotation of the seed crystal 30 is accelerated to 15 rpm in 1 second, held for 3 seconds, decelerated for 1 second, and stopped for 3 seconds (in each cycle P31)." The control unit 34 reads as the control information of the mixed melt 24, i.e., the reaction vessel 52, and the like for realizing this pattern, for example, the control information which indicates "the following is repeated: the rotation of the reaction vessel 52 is accelerated to 15 rpm in 1 second in the direction opposite to the rotation of the seed crystal 30 and held for 3 seconds; and the rotation of the reaction vessel 52 is accelerated to 30 rpm in 1 second in the above direction, held for 3 seconds, decelerated for 2 seconds, and stopped for 3 seconds (in each cycle P310)." The control unit 34 controls the rotation of each of the reaction vessel 52 and the seed crystal 30 according to the read control information. This control causes the seed crystal 30 to repeat the fluctuations in the rotation speed (Seed speed) indicated by a line 106B in FIG. 37. This control causes the mixed melt 24 to repeat the fluctuations in the rotation speed (flow rate) indicated by a line 106C in FIG. 37. As a result, the rotation of the seed crystal 30 and the mixed melt 24 realizes the fluctuations in the relative speed of the pattern indicated by the line 106A.

In the production apparatus 2 of the present embodiment, as described above, at least one of the mixed melt 24 and the seed crystal 30 is rotated in the crystal growth step, and the relative speed between the mixed melt 24 and the seed crystal 30 in the crystal growth step is repeatedly fluctuated in accordance with one or a plurality of types of predetermined patterns, wherein the maximum value of the relative speed indicated by each pattern is 0.01 m/s or more.

It is accordingly considered that high-quality group 13 nitride crystals can be produced.

The production apparatus 2 of the present embodiment includes: a control device (control unit 34) such as a CPU; a storage device (storage unit 35) such as a ROM and a RAM; an external storage device such as an HDD and a CD drive; a display apparatus (display unit) such as a display device; and an input device (operating unit) such as a keyboard and a mouse. The production apparatus 2 of the present embodiment has a hardware configuration using an ordinary computer.

A program for executing the rotation control in the crystal growth step which is carried out in the production apparatus 2 of the present embodiment is stored as an installable or executable file in a computer-readable storage medium, such as CD-ROMs, flexible disks (FD), CD-Rs, and digital versatile disks (DVD), and provided.

The program for executing the rotation control in the crystal growth step which is carried out in the production apparatus 2 of the present embodiment may be stored in a computer connected to a network such as the Internet, and may be provided by downloading via the network. The program for executing the rotation control in the crystal growth step which is carried out in the production apparatus 2 of the present embodiment may be provided or distributed via the network such as the Internet.

The program for executing the rotation control in the crystal growth step which is carried out in the production apparatus 2 of the present embodiment may be incorporated into a ROM or the like in advance and provided.

The program for executing the rotation control in the crystal growth step which is carried out in the production apparatus 2 of the present embodiment contains modules including a function part for executing position control processing as described above. A CPU (processor) as a practical hardware reads out the program from the storage medium and executes it so that the function part for executing the program is loaded in a main storage device and generated in the main storage device.

Although the present embodiment is described above, the present embodiment is illustrative only and is not intended to limit the scope of the invention. This novel embodiment can be practiced in various other forms, and various omissions, substitutions, and changes can be made without departing from the scope of the invention as defined in the claims.

EXAMPLES

The present invention will be described below in more detail by way of Examples, but the present invention is not limited to these Examples. The reference numerals correspond to the configuration of the production apparatus 2 described above.

16

- Production of Seed Crystal -

First, a seed crystal used for producing a group 13 nitride crystal was produced according to the following production method.

Production Example of Seed Crystal

A needle-like seed crystal produced in the same conditions as in Example 1 in Japanese Laid-open Patent Publication No. 2011-213579 was prepared as the seed crystal 30. The seed crystal 30 was a needle-like one having a length of 55 mm in the c-axis direction and a length of 1 mm in the direction perpendicular to the c-axis. The produced seed crystal 30 was used to produce group 13 nitride crystals in the following Examples and Comparative Example.

- Production of Group 13 Nitride Crystal -

Next, group 13 nitride crystals were produced.

Example 1

In this Example, a group 13 nitride crystal 19 was produced by growing the nitride crystal 27 from the seed crystal 30 in the production apparatus 2A illustrated in FIG. 4.

First, the inner vessel 51 was detached from the production apparatus 2 at the valve 61 part, and placed in a glove box with an Ar atmosphere. Next, the seed crystal 30 was installed in the reaction vessel 52 made of alumina and having an inner diameter of 140 mm and a depth of 100 mm. A supporting member having a 4 mm deep hole was provided at the center of the bottom in the reaction vessel 52, and the seed crystal 30 was inserted and retained to/by the hole of the supporting member.

Next, as a flux, sodium (Na) was heated to become a liquid and placed in the reaction vessel 52. Gallium was placed therein after sodium was solidified. The molar ratio of gallium and sodium was set to 0.25:0.75 in this Example.

Subsequently, the reaction vessel 52 was installed in the inner vessel 51 under a high grade Ar gas atmosphere in the glove box. The valve 61 was then closed to seal the inner vessel 51 filled with Ar gas, and the inside of the reaction vessel 52 was shielded from an external atmosphere. Next, the inner vessel 51 was taken out from the glove box and incorporated into the production apparatus 2A. Specifically, the inner vessel 51 was installed at a certain position with respect to the heater 53, and connected to the gas supply pipe 54 at the valve 61 part.

Next, argon gas was purged from the inner vessel 51 and then nitrogen gas was introduced thereto from the nitrogen supply pipe 57. The total pressure in the inner vessel 51 was adjusted to 1.2 MPa by controlling the pressure with the pressure controller 56 and opening the valve 55. The valve 55 was then closed and the pressure controller 56 was set at 3.0 MPa.

Next, the heater 53 was energized to heat the reaction vessel 52 to a crystal growth temperature. The crystal growth temperature was 870 °C. The valve 55 was then opened to adjust the nitrogen gas pressure to 2.8 MPa.

That is, the temperature condition was 870 °C and the nitrogen gas pressure was 2.8 MPa in the crystal growth step.

Under such conditions, the reaction vessel 52 was rotated in one direction (see the direction of the arrow A in FIG. 4) while the following sequence was repeated to grow the crystal for 1000 hours: the rotation was accelerated to 15 rpm in 1 second, held at 15 rpm for 3 seconds, decelerated to 0 rpm in 1 second, and accelerated to 15 rpm in 1 second again without providing a rotation stop period.

Specifically, as described using FIG. 8, the control unit 34 read from the storage unit 35 the control information corresponding to the pattern specified by the waveform indicated by a part of the line 77A in each cycle P2 illustrated in FIG. 8 to execute the following control. Specifically, the control unit 34 read as the control information on the rotation speed of the reaction vessel 52 for realizing this pattern, the information which indicated "the following is repeated: the rotation of the reaction vessel 52 is accelerated to 15 rpm in 1 second, held for 3 seconds, decelerated for 1 second, and stopped for 3 seconds." The control unit 34 controlled the rotation of the reaction vessel 52 according to the read control information. This control was performed by having the control unit 34 execute the program stored in a ROM (not shown) in advance.

It was confirmed that this control caused the seed crystal 30 to show the fluctuations in the rotation speed indicated by the line 77B in FIG. 8. It was also confirmed that the fluctuations in the rotation speed of the reaction vessel 52 caused the mixed melt 24 to show the fluctuations in the flow rate (rotation speed) indicated by the line 77C in FIG. 8.

It was confirmed that, as a result, the rotation of the reaction vessel 52 realized the fluctuations in the relative speed of the pattern indicated by the line 77A.

The maximum value of the relative speed between the seed crystal 30 and the mixed melt 24 was 0.032 m/s.

In the crystal growth step, the period T1 was 0 seconds and the period T2 was 8 seconds, which satisfied the relationship of T1 < T2, wherein the period T1 was a period with the relative speed satisfying the relationship represented by the above Formula (1) and the period T2 was a period with the relative speed satisfying the relationship represented by the above Formula (2).

The value of Vmax/Vmin during the period T2 was 6.5, which was less than 10, wherein the Vmax/Vmin was the ratio of the maximum value Vmax to the minimum value Vmin of the relative speed in the main growth surface of the seed crystal 30.

The rate of change (acceleration and deceleration) during the acceleration and deceleration in the crystal growth step was 900 rpm/min.

The relative speed in the crystal growth step was calculated using thermal fluid simulation. The periods T1 and T2 were also calculated from the results of the thermal fluid simulation similarly. The acceleration and deceleration were calculated from the above sequence.

After the crystal growth step, a bulk GaN crystal was produced which had a length of 65 mm in the c-axis direction and a length of 55 mm in the direction perpendicular to the c-axis, as a group 13 nitride crystal.

The amount of crude crystal deposition in the produced bulk GaN crystal was measured using an electronic balance, and it was found that the amount of crude crystal deposition in the produced bulk GaN crystal accounted for 4% of the total yield.

The produced bulk GaN crystal was sliced parallel to the c-plane and irradiated with visible light from the back side to evaluate that inclusions were contained in light-impermeable parts. This procedure was used to observe the sliced bulk GaN crystal to find that inclusions were contained in 5% of the entire c-plane. Coloring was not observed in the crystal. The produced bulk GaN crystal was analyzed by XRC to obtain FWHM of 32 arc sec.

Therefore, the group 13 nitride crystal produced in Example 1 was confirmed to be a group 13 nitride crystal having higher quality than a group 13 nitride crystal produced in Comparative Example to be described below.

(Example 2)

In this Example, a group 13 nitride crystal 19 was produced by growing the nitride crystal 27 from the seed crystal 30 in the production apparatus 2B illustrated in FIG. 5.

First, the inner vessel 51 was detached from the production apparatus 2B at the valve 61 part, and placed in a glove box with an Ar atmosphere. Next, the seed crystal 30 was installed at one end of the supporting member 38 in the longitudinal direction, wherein the supporting member 38 was installed at an upper inner wall of the external pressure resistant vessel 50.

The same flux as in Example 1 was used. The reaction vessel 52 retaining the mixed melt 24 was then installed in the inner vessel 51 in the same manner as in Example 1. The valve 61 was then closed to seal the inner vessel 51 filled with Ar gas, and the inside of the reaction vessel 52 was shielded from an external atmosphere. Next, the inner vessel 51 was taken out from the glove box and incorporated into the production apparatus 2B. Specifically, the inner vessel 51 was installed at a certain position with respect to the heater 53, and connected to the gas supply pipe 54 at the valve 61 part.

Next, argon gas was purged from the inner vessel 51 and then nitrogen gas was introduced thereto from the nitrogen supply pipe 57. The total pressure in the inner vessel 51 was adjusted to 1.2 MPa by controlling the pressure with the pressure controller 56 and opening the valve 55. Subsequently, the valve 55 was closed to set the pressure controller 56 at 3.0 MPa.

Next, the heater 53 was energized to heat the reaction vessel 52 to a crystal growth temperature. The crystal growth temperature was 870 °C. The valve 55 was then opened to adjust the nitrogen gas pressure to 2.8 MPa.

That is, the temperature condition was 870 °C and the nitrogen gas pressure was 2.8 MPa in the crystal growth step in the same manner as in Example 1.

Under such conditions, the reaction vessel 52 was rotated in one direction (see the direction of the arrowed line A in FIG. 5) while the following sequence was repeated to grow the crystal for 1000 hours: the rotation was accelerated to 15 rpm in 1 second, held at 15 rpm for 3 seconds, then decelerated in 1 second, and stopped for 3 seconds.

Specifically, as described using FIG. 20, the control unit 34 read from the storage unit 35 the control information corresponding to the pattern specified by the waveform indicated by a part of the line 89A in each cycle P14 illustrated in FIG. 20. Specifically, the control unit 34 read as the control information on the rotation speed of the reaction vessel 52 for realizing this pattern, the information which indicated "the following is repeated: the rotation of the reaction vessel 52 is accelerated to 15 rpm in 1 second, held for 3 seconds, decelerated for 1 second, and stopped for 3 seconds." The control unit 34 controlled the rotation of the reaction vessel 52 according to the read control information. This control was performed by having the control unit 34 execute the program stored in ROM (not shown) in advance.

It was confirmed that this control caused the mixed melt 24 to show the fluctuations in the melt speed (rotation speed) indicated by the line 89C in FIG. 20. It was also confirmed that, as a result, the rotation of the mixed melt 24 realized the fluctuations in the relative speed of the pattern indicated by the line 89A.

As a result, the maximum value of the relative speed between the seed crystal 30 and the mixed melt 24 was 0.047 m/s in this Example.

In the crystal growth step, the period T1 was 0 seconds and the period T2 was 8 seconds, which satisfied the relationship of T1 < T2, wherein the period T1 was a period with the relative speed satisfying the relationship represented by the above Formula (1) and the period T2 was a period with the relative speed satisfying the relationship represented by the above Formula (2).

The value of Vmax/Vmin during the period T2 was 5.3, which was less than 10, wherein the Vmax/Vmin was the ratio of the maximum value Vmax to the minimum value Vmin of the relative speed in the main growth surface of the seed crystal 30.

The rate of change (acceleration and deceleration) during the acceleration and deceleration in the crystal growth step was 900 rpm/min.

The relative speed and the periods T1 and T2 were calculated in the same manner as in Example 1.

After this crystal growth step, a bulk GaN crystal was produced which had a length of 65 mm in the c-axis direction and a length of 55 mm in the direction perpendicular to the c-axis, as a group 13 nitride crystal.

The amount of crude crystal deposition in the produced bulk GaN crystal was measured in the same manner as in Example 1, and it was found that the amount of crude crystal deposition in the produced bulk GaN crystal accounted for 2% of the total yield.

The produced bulk GaN crystal was sliced parallel to the c-plane and observed in the same manner as in Example 1 to find that inclusions were contained in 2% of the entire c-plane. Coloring was not observed in the crystal. The produced bulk GaN crystal was analyzed by XRC to obtain FWHM of 25 arc sec.

Therefore, the group 13 nitride crystal produced in Example 2 was confirmed to be a group 13 nitride crystal having higher quality than a group 13 nitride crystal produced in Comparative Example 1 to be described below.

(Example 3)

In this Example, a group 13 nitride crystal was produced by growing the nitride crystal from the seed crystal 30 in the production apparatus 2C illustrated in FIG. 6.

A group 13 nitride crystal was produced in the same manner as in Example 2 except that the rotation control in the crystal growth step was as follows: "the seed crystal 30 was rotated in one direction while the rotation was accelerated to 15 rpm in 1 second and then held at a speed of 15 rpm. The reaction vessel 52 was rotated in the direction opposite to the rotation of the seed crystal 30 while the rotation was accelerated to 15 rpm in 1 second, held at 15 rpm for 3 seconds, then decelerated to 0 rpm in 1 second, stopped for 3 seconds, and then accelerated to 15 rpm in 1 second again. This cycle was repeated."

Specifically, as described using FIG. 31, the control unit 34 read from the storage unit 35 the control information corresponding to the pattern specified by the waveform indicated by a part of the line 100A in each cycle P25 illustrated in FIG. 31. Specifically, the control unit 34 read as the control information on the rotation speed of the seed crystal 30 for realizing this pattern, the control information which indicated "the rotation of the seed crystal 30 is accelerated to 15 rpm in 1 second and then held." The control unit 34 read as the control information of the mixed melt 24, i.e., the reaction vessel 52, and the like for realizing this pattern, the control information which indicated "the following is repeated: the rotation of the reaction vessel 52 is accelerated to 15 rpm in 1 second in the direction opposite to the rotation of the seed crystal 30, held for 3 seconds, decelerated for 1 second, and stopped for 3 seconds." The control unit 34 controlled the rotation of each of the reaction vessel 52 and the seed crystal 30 according to the read control information. This control was performed by having the control unit 34 execute the program stored in a ROM (not shown) in advance.

It was confirmed that this control caused the seed crystal 30 to show the fluctuations in the rotation speed (Seed speed) indicated by the line 100B in FIG. 31. It was also confirmed that this control caused the mixed melt 24 to show the fluctuations in the rotation speed (flow rate) indicated by the line 100C in FIG. 31. It was confirmed that, as a result, the rotation of the seed crystal 30 and the mixed melt 24 realized the fluctuations in the relative speed of the pattern indicated by the line 100A.

As a result, the maximum value of the relative speed between the seed crystal 30 and the mixed melt 24 was 0.094 m/s in this Example.

In the crystal growth step, the period T1 was 0 seconds and the period T2 was 8 seconds, which satisfied the relationship of T1 < T2, wherein the period T1 was a period with the relative speed satisfying the relationship represented by the above Formula (1) and the period T2 was a period with the relative speed satisfying the relationship represented by the above Formula (2).

The value of Vmax/Vmin during the period T2 was 3.7, which was less than 10, wherein the Vmax/Vmin was the ratio of the maximum value Vmax to the minimum value Vmin of the relative speed in the main growth surface of the seed crystal 30.

The rate of change (acceleration and deceleration) during the acceleration and deceleration in the crystal growth step was 900 rpm/min.

The relative speed and the periods T1 and T2 were calculated in the same manner as in Example 1.

After this crystal growth step, a bulk GaN crystal was produced which had a length of 65 mm in the c-axis direction and a length of 55 mm in the direction perpendicular to the c-axis, as a group 13 nitride crystal. Crude crystal deposition was not observed.

The amount of crude crystal deposition in the produced bulk GaN crystal was measured in the same manner as in Example 1, and it was found that the amount of crude crystal deposition in the produced bulk GaN crystal accounted for 2% of the total yield.

The produced bulk GaN crystal was sliced parallel to the c-plane and observed in the same manner as in Example 1. As a result, neither inclusions nor coloring was observed in the entire c-plane. The produced bulk GaN crystal was analyzed by XRC to obtain FWHM of 18 arc sec.

Therefore, the group 13 nitride crystal produced in Example 3 was confirmed to be a group 13 nitride crystal having higher quality than a group 13 nitride crystal produced in Comparative Example 1 to be described below.

(Example 4)

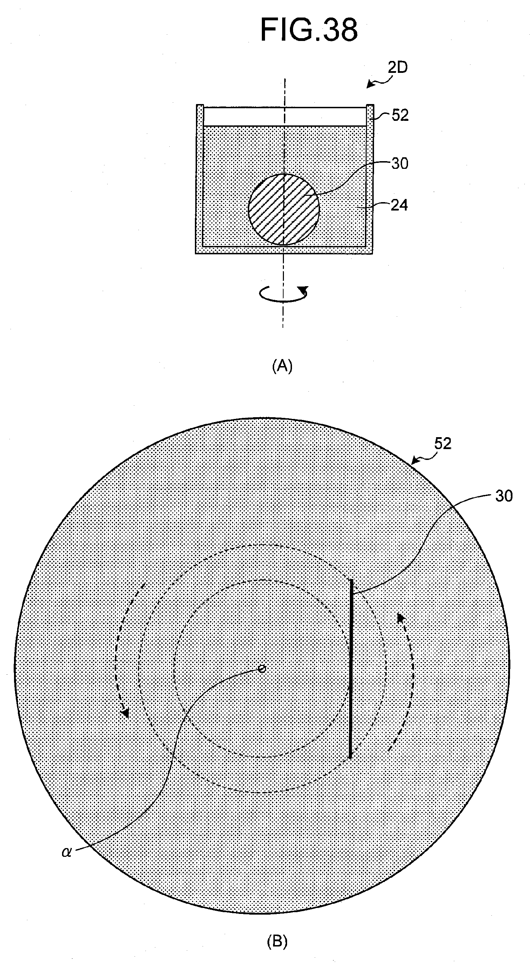

In this Example, a group 13 nitride crystal 19 was produced by growing the nitride crystal 27 from the seed crystal 30 in the production apparatus 2D illustrated in FIG. 38. FIG. 38A shows a side view of the reaction vessel 52 part, and FIG. 38B shows a top view of the reaction vessel 52 part.

The production apparatus 2D illustrated in FIG. 38 had a configuration where the reaction vessel 52 was rotated, as in the production apparatus 2A illustrated in FIG. 4, and used a plate-like seed crystal 30 having a c-plane with φ 50.8 mm and a thickness of 0.4 mm in the c-axis direction, instead of the long seed crystal 30. In the production apparatus 2D, the plate-like seed crystal 30 was installed parallel to the tangent of the rotation direction (direction of an arrowed line A in FIG. 38) of the reaction vessel 52 at the inside bottom of the reaction vessel 52. The production apparatus 2D had the same configuration as the production apparatus 2A illustrated in FIG. 4 except that the plate-like seed crystal 30, instead of the long seed crystal 30, was installed at the above position shifted from the rotating center α in the reaction vessel 52.

The same flux as in Example 1 was used. The reaction vessel 52 retaining the mixed melt 24 was then installed in the inner vessel 51 in the same manner as in Example 1. The valve 61 was then closed to seal the inner vessel 51 filled with Ar gas, and the inside of the reaction vessel 52 was shielded from an external atmosphere. Next, the inner vessel 51 was taken out from the glove box and incorporated into the production apparatus 2B. Specifically, the inner vessel 51 was installed at a certain position with respect to the heater 53, and connected to the gas supply pipe 54 at the valve 61 part.

Next, argon gas was purged from the inner vessel 51 and then nitrogen gas was introduced thereto from the nitrogen supply pipe 57. The total pressure in the inner vessel 51 was adjusted to 1.2 MPa by controlling the pressure with the pressure controller 56 and opening the valve 55. Subsequently, the valve 55 was closed to set the pressure controller 56 at 3.0 MPa.

Next, the heater 53 was energized to heat the reaction vessel 52 to a crystal growth temperature. The crystal growth temperature was 870 °C. The valve 55 was then opened to adjust the nitrogen gas pressure to 2.8 MPa.

That is, the temperature condition was 870 °C and the nitrogen gas pressure was 2.8 MPa in the crystal growth step in the same manner as in Example 1.

Under such conditions, the reaction vessel 52 was rotated in one direction (see the direction of the arrowed line A in FIG. 38) while the following sequence was repeated in the same manner as in Example 1 to grow the crystal for 1000 hours: the rotation was accelerated to 15 rpm in 1 second, held at 15 rpm for 3 seconds, decelerated to 0 rpm in 1 second, and accelerated to 15 rpm in 1 second again without providing a rotation stop period.

Specifically, as described using FIG. 8, the control unit 34 read from the storage unit 35 the control information corresponding to the pattern specified by the waveform indicated by a part of the line 77A in each cycle P2 illustrated in FIG. 8 to execute the following control. Specifically, the control unit 34 read as the control information on the rotation speed of the reaction vessel 52 for realizing this pattern, the information which indicated "the following is repeated: the rotation of the reaction vessel 52 is accelerated to 15 rpm in 1 second, held for 3 seconds, decelerated for 1 second, and stopped for 3 seconds." The control unit 34 controlled the rotation of the reaction vessel 52 according to the read control information. This control was performed by having the control unit 34 execute the program stored in a ROM (not shown) in advance.

It was confirmed that this control caused the mixed melt 24 to show the fluctuations in the flow rate (rotation speed) in the same manner as in Example 1.

The maximum value of the relative speed between the seed crystal 30 and the mixed melt 24 was 0.063 m/s.

In the crystal growth step, the period T1 was 0 seconds and the period T2 was 8 seconds, which satisfied the relationship of T1 < T2, wherein the period T1 was a period with the relative speed satisfying the relationship represented by the above Formula (1) and the period T2 was a period with the relative speed satisfying the relationship represented by the above Formula (2).

The value of Vmax/Vmin during the period T2 was 9.7, which was less than 10, wherein the Vmax/Vmin was the ratio of the maximum value Vmax to the minimum value Vmin of the relative speed in the main growth surface of the seed crystal 30.

The rate of change (acceleration and deceleration) during the acceleration and deceleration in the crystal growth step was 900 rpm/min.

The relative speed in the crystal growth step was calculated using thermal fluid simulation. The periods T1 and T2 were also calculated from the results of the thermal fluid simulation similarly. The acceleration and deceleration were calculated from the above sequence.

After the crystal growth step, a bulk GaN crystal was produced which had a length of 20 mm in the c-axis direction and a length of 65 mm in the direction perpendicular to the c-axis, as a group 13 nitride crystal.

The amount of crude crystal deposition in the produced bulk GaN crystal was measured using an electronic balance, and it was found that the amount of crude crystal deposition in the produced bulk GaN crystal accounted for 27% of the total yield.

The produced bulk GaN crystal was sliced parallel to the c-plane and irradiated with visible light from the back side to evaluate that inclusions were contained in light-impermeable parts. This procedure was used to observe the sliced bulk GaN crystal to find that inclusions were contained in 21 % of the entire c-plane. Coloring was not observed in the crystal. The produced bulk GaN crystal was analyzed by XRC to obtain FWHM of 38 arc sec.

Therefore, the group 13 nitride crystal produced in Example 4 was confirmed to be a group 13 nitride crystal having higher quality than a group 13 nitride crystal produced in Comparative Example to be described below.

(Comparative Example 1)

Next, a group 13 nitride crystal was produced in the same manner as in Example 1 except that the rotation control in the crystal growth step was as follows: "the relative rotation was kept constant by alternately switching the rotation of the reaction vessel 52 to positive rotation and negative rotation after the flow rate of the mixed melt 24 decreased to 0.1 times the maximum flow rate or lower."

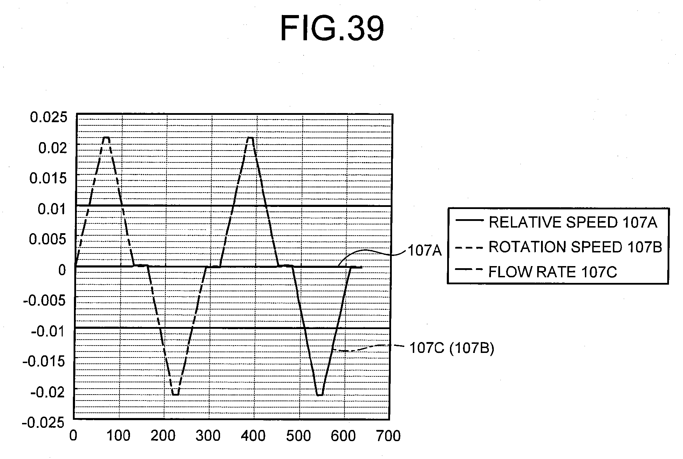

FIG. 39 is a figure illustrating the relative speed between the seed crystal 30 and the mixed melt 24, and the rotation speed of each of the seed crystal 30 and mixed melt 24 in Comparative Example 1.

As illustrated in FIG. 39, the rotation of the reaction vessel 52 was alternately switched to positive rotation and negative rotation after the flow rate of the mixed melt 24 decreased to 0.1 times the maximum flow rate or lower (see lines 107C and 107B), in order to keep constant the relative speed between the seed crystal 30 and the mixed melt 24 (line 107A).

It was confirmed that the relative speed in the crystal growth step was "zero" and constant as indicated by the line 107A. The relative speed was calculated in the same manner as in Example 1.

After this crystal growth step, a bulk GaN crystal of Comparative Example was produced which had a length of 60 mm in the c-axis direction and a length of 40 mm in the direction perpendicular to the c-axis, as a group 13 nitride crystal of Comparative Example.

The amount of crude crystal deposition in the produced bulk GaN crystal of Comparative Example was measured in the same manner as in Example 1. As a result, it was found that the amount of crude crystal deposition in the produced bulk GaN crystal accounted for 57% of the total yield, and the amount of crude crystal deposition was 14 or more times larger than that in the Examples.

The produced bulk GaN crystal of this Comparative Example was sliced parallel to the c-plane and observed in the same manner as in Example 1 to find that inclusions were contained in 67% of the entire c-plane, showing that the amount of inclusions was larger than that in Examples. The produced bulk GaN crystal of this Comparative Example was analyzed by XRC to obtain FWHM of 78 arc sec.

Therefore, the group 13 nitride crystal produced in Comparative Example 1 was a group 13 nitride crystal having lower quality than the group 13 nitride crystals produced in Examples.

The present invention can provide a method for producing a high-quality group 13 nitride crystal.

Although the invention has been described with respect to specific embodiments for a complete and clear disclosure, the appended claims are not to be thus limited but are to be construed as embodying all modifications and alternative constructions that may occur to one skilled in the art that fairly fall within the scope of the appended claims.

The present application claims priority to Japanese Patent Application No. 2013-051056 filed in Japan on March 13, 2013.

**Claims**

1. A method for producing a group 13 nitride crystal, comprising: a crystal growth step of reacting nitrogen and a mixed melt (24) containing at least a group 13 metal and at least one of an alkali metal and an alkaline earth metal, in the mixed melt (24), to grow a nitride crystal (27) on a seed crystal (30)

   wherein at least one of the mixed melt (24) and the seed crystal (30) is rotated in the crystal growth step, a relative speed between the mixed melt (24) and the seed crystal (30) in the crystal growth step is repeatedly fluctuated in accordance with one or a plurality of types of predetermined patterns, and a maximum value of the relative speed indicated by the pattern is 0.01 m/s or more,

   wherein a period T1 with the relative speed satisfying a relationship represented by the following Formula (1) and a period T2 with the relative speed satisfying a relationship represented by the following Formula (2) in the pattern satisfy a relationship represented by the following Formula (3),

$$0 \le V < 0.01 \qquad\qquad (1)$$

$$0.01 \le V \qquad\qquad (2)$$

$$T1 < T2 \qquad\qquad (3)$$

   wherein in the Formulas (1) and (2), V represents the relative speed (m/s),

   **characterized in that** a ratio of a maximum value Vmax to a minimum value Vmin of the relative speed in a main growth surface of the seed crystal (30) in the crystal growth step satisfies a relationship represented by the following Formula (4) during the period T2 in the pattern,

$$Vmax/Vmin < 10 \qquad (4).$$

2. The method for producing a group 13 nitride crystal according to claim 1, wherein
   the pattern is specified by combining an increase of rotation speed of at least one of the mixed melt (24) and the seed crystal (30) with at least one of a decrease of rotation speed and constant rotation speed thereof.

3. The method for producing a group 13 nitride crystal according to any one of claims 1 to 2, wherein
   a rate of change in the rotation speed during accelerated rotation or decelerated rotation of at least one of the mixed melt (24) and the seed crystal (30) is 50 rpm/min or more in the crystal growth step.

4. The method for producing a group 13 nitride crystal according to any one of claims 1 to 3, wherein
   a main growth surface of the seed crystal (30) is parallel to a tangent of a rotation direction of the seed crystal (30).

5. The method for producing a group 13 nitride crystal according to any one of claims 1 to 4, wherein
   a rotation axis of the mixed melt (24) is coincident with a rotation axis of the seed crystal (30).

6. The method for producing a group 13 nitride crystal according to any one of claims 1 to 5, wherein
   the mixed melt (24) is rotated by rotating a crucible (52) retaining the mixed melt (24), and a rotation axis of the crucible (52) is coincident with a rotation axis of the seed crystal (30).

7. A production apparatus used for the method for producing a group 13 nitride crystal according to any one of claims 1 to 6, comprising:

   a drive unit (32) for rotating at least one of the mixed melt (24) and the seed crystal (30); and
   a control unit (34) for controlling the drive unit (32) so that at least one of the mixed melt (24) and the seed crystal (30) is rotated in the crystal growth step, the relative speed between the mixed melt (24) and the seed crystal (30) in the crystal growth step is repeatedly fluctuated in accordance with one or a plurality of types of predetermined patterns, and a maximum value of the relative speed indicated by the pattern is 0.01 m/s or more, wherein a period T1 with the relative speed satisfying a relationship represented by the following Formula (1) and a period T2 with the relative speed satisfying a relationship represented by the following Formula (2) in the pattern satisfy a relationship represented by the following Formula (3),

$$0 \leq V < 0.01 \qquad\qquad (1)$$

$$0.01 \leq V \qquad\qquad (2)$$

$$T1 < T2 \qquad\qquad (3)$$

wherein in the Formulas (1) and (2), V represents the relative speed (m/s),
**characterized in that** a ratio of a maximum value Vmax to a minimum value Vmin of the relative speed in a main growth surface of the seed crystal (30) in the crystal growth step satisfies a relationship represented by the following Formula (4) during the period T2 in the pattern,

$$Vmax/Vmin < 10 \qquad (4).$$

**Patentansprüche**

1. Verfahren zum Herstellen eines Gruppe-13-Nitridkristalls, das Folgendes umfasst: einen Kristallwachstumsschritt, in dem Stickstoff mit einer gemischten Schmelze (24), die wenigstens ein Gruppe-13-Metall enthält, und mit einem Alkalimetall und/oder einem Erdalkalimetall in der gemischten Schmelze (24) reagieren, um auf einem Keimkristall (30) einen Nitridkristall (27) wachsen zu lassen,
wobei die gemischte Schmelze (24) und/oder der Keimkristall (30) in dem Kristallwachstumsschritt gedreht werden,
wobei eine Relativgeschwindigkeit zwischen der gemischten Schmelze (24) und dem Keimkristall (30) in dem Kristallwachstumsschritt entsprechend einem oder mehreren Typen vorgegebener Muster wiederholt verändert wird und ein Maximalwert der Relativgeschwindigkeit, der durch das Muster angegeben wird, 0,01 m/s oder mehr beträgt,
wobei eine Periode T1, in der die Relativgeschwindigkeit eine Beziehung erfüllt, die durch die folgende Formel (1) gegeben ist, und eine Periode T2, in der die Relativgeschwindigkeit eine Beziehung erfüllt, die durch die folgende Formel (2) gegeben ist, in dem Muster eine Beziehung erfüllen, die durch die folgende Formel (3) gegeben ist:

$$0 \leq V < 0{,}01 \qquad\qquad (1)$$

$$0{,}01 \leq V \qquad\qquad (2)$$

$$T1 < T2 \qquad\qquad (3)$$

wobei V in den Formeln (1) und (2) die Relativgeschwindigkeit (m/s) repräsentiert,
**dadurch gekennzeichnet, dass** ein Verhältnis des Maximalwerts Vmax zu einem Minimalwert Vmin der Relativgeschwindigkeit in einer Hauptwachstumsfläche des Keimkristalls (30) in dem Kristallwachstumsschritt während der Periode T2 in dem Muster eine Beziehung erfüllt, die durch die folgende Formel (4) gegeben ist:

$$Vmax/Vmin < 10 \qquad\qquad (4).$$

2. Verfahren zum Herstellen eines Gruppe-13-Nitridkristalls nach Anspruch 1,
wobei das Muster durch Kombinieren einer Erhöhung der Drehzahl der gemischten Schmelze (24) und/oder des Keimkristalls (30) mit einer Erniedrigung der Drehzahl und/oder einer konstanten Drehzahl spezifiziert ist.

3. Verfahren zum Herstellen eines Gruppe-13-Nitridkristalls nach einem der Ansprüche 1 bis 2, wobei

in dem Kristallwachstumsschritt eine Änderungsrate der Drehzahl während einer beschleunigten Drehung oder einer verzögerten Drehung der gemischten Schmelze (24) und/oder des Keimkristalls (30) 50 min$^{-1}$/min oder mehr beträgt.

4. Verfahren zum Herstellen eines Gruppe-13-Nitridkristalls nach einem der Ansprüche 1 bis 3, wobei eine Hauptwachstumsfläche des Keimkristalls (30) zu einer Tangente einer Drehrichtung des Keimkristalls (30) parallel ist.

5. Verfahren zum Herstellen eines Gruppe-13-Nitridkristalls nach einem der Ansprüche 1 bis 4, wobei eine Drehachse der gemischten Schmelze (24) mit einer Drehachse des Keimkristalls (30) zusammenfällt.

6. Verfahren zum Erzeugen eines Gruppe-13-Nitridkristalls nach einem der Ansprüche 1 bis 5, wobei die gemischte Schmelze (24) durch Drehen eines Schmelztiegels (52), der die gemischte Schmelze (24) enthält, gedreht wird und eine Drehachse des Schmelztiegels (52) mit einer Drehachse des Keimicristalls (30) zusammenfällt.

7. Herstellungsvorrichtung, die für das Verfahren zum Herstellen eines Gruppe-13-Nitridkristalls nach einem der Ansprüche 1 bis 6 verwendet wird, die Folgendes umfasst:

   eine Antriebseinheit (32), um die gemischte Schmelze (24) und/oder den Keimkristall (30) zu drehen; und eine Steuereinheit (34) zum Steuern der Antriebseinheit (32), so dass die gemischte Schmelze (24) und/oder der Keimkristall (30) in dem Kristallwachstumsschritt gedreht werden, wobei die Relativgeschwindigkeit zwischen der gemischten Schmelze (24) und dem Keimkristall (30) in dem Kristallwachstumsschritt entsprechend einem oder mehreren Typen vorgegebener Muster wiederholt geändert wird und ein Maximalwert der Relativgeschwindigkeit, der durch das Muster angegeben wird, 0,01 m/s oder mehr beträgt, wobei eine Periode T1, in der die Relativgeschwindigkeit eine Beziehung erfüllt, die durch die folgende Formel (1) gegeben ist, und eine Periode T2, in der die Relativgeschwindigkeit eine Beziehung erfüllt, die durch die folgende Formel (2) gegeben ist, in dem Muster eine Beziehung erfüllen, die durch die folgende Formel (3) gegeben ist:

$$0 \le V < 0,01 \qquad\qquad (1)$$

$$0,01 \le V \qquad\qquad (2)$$

$$T1 < T2 \qquad\qquad (3)$$

   wobei V in den Formeln (1) und (2) die Relativgeschwindigkeit (m/s) repräsentiert, **dadurch gekennzeichnet, dass** ein Verhältnis des Maximalwerts Vmax zu einem Minimalwert Vmin der Relativgeschwindigkeit in einer Hauptwachstumsfläche des Keimkristalls (30) in dem Kristallwachstumsschritt während der Periode T2 in dem Muster eine Beziehung erfüllt, die durch die folgende Formel (4) gegeben ist:

$$Vmax/Vmin < 10 \qquad\qquad (4).$$

## Revendications

1. Procédé de production d'un cristal de nitrure du groupe 13, comprenant : une étape de croissance cristalline consistant à faire réagir de l'azote et un liquide mixte (24) contenant au moins un métal du groupe 13 et au moins l'un d'un métal alcalin et d'un métal alcalino-terreux, dans le liquide mixte (24), pour faire croître un cristal de nitrure (27) sur un germe cristallin (30)

   dans lequel au moins l'un du liquide mixte (24) et du germe cristallin (30) est soumis à une rotation au cours de l'étape de croissance cristalline, une vitesse relative entre le liquide mixte (24) et le germe cristallin (30) au cours de l'étape de croissance cristalline est soumise à des fluctuations répétées suivant un ou une pluralité de types de schémas prédéterminés, et une valeur maximale de la vitesse relative indiquée par le schéma est de 0,01 m/s ou plus,

dans lequel une période T1 avec la vitesse relative satisfaisant une relation représentée par la Formule (1) suivante et une période T2 avec la vitesse relative satisfaisant une relation représentée par la Formule (2) suivante dans le schéma satisfont une relation représentée par la Formule (3) suivante,

$$0 \leq V < 0,01 \qquad (1)$$

$$0,01 \leq V \qquad (2)$$

$$T1 < T2 \qquad (3)$$

dans lequel dans les Formules (1) et (2), V représente la vitesse relative (m/s),
**caractérisé en ce qu'**un rapport d'une valeur maximale Vmax à une valeur minimale Vmin de la vitesse relative dans une surface de croissance principale du germe cristallin (30) au cours de l'étape de croissance cristalline satisfait une relation représentée par la Formule (4) suivante au cours de la période T2 dans le schéma,

$$Vmax/Vmin < 10 \qquad (4).$$

2. Procédé de production d'un cristal de nitrure du groupe 13 selon la revendication 1, dans lequel

le schéma est spécifié en combinant une augmentation de la vitesse de rotation d'au moins l'un du liquide mixte (24) et du germe cristallin (30) avec au moins l'une d'une réduction de la vitesse de rotation et d'une vitesse de rotation constante de ceux-ci.

3. Procédé de production d'un cristal de nitrure du groupe 13 selon l'une quelconque des revendications 1 à 2, dans lequel

un taux de changement de la vitesse de rotation au cours d'une rotation accélérée ou d'une rotation décélérée d'au moins l'un du liquide mixte (24) et du germe cristallin (30) est de 50 tr/min/min ou plus au cours de l'étape de croissance cristalline.

4. Procédé de production d'un cristal de nitrure du groupe 13 selon l'une quelconque des revendications 1 à 3, dans lequel

une surface de croissance principale du germe cristallin (30) est parallèle à une tangente d'une direction de rotation du germe cristallin (30).

5. Procédé de production d'un cristal de nitrure du groupe 13 selon l'une quelconque des revendications 1 à 4, dans lequel

un axe de rotation du liquide mixte (24) coïncide avec un axe de rotation du germe cristallin (30).

6. Procédé de production d'un cristal de nitrure du groupe 13 selon l'une quelconque des revendications 1 à 5, dans lequel

le liquide mixte (24) est soumis à une rotation par rotation d'un creuset (52) retenant le liquide mixte (24), et un axe de rotation du creuset (52) coïncide avec un axe de rotation du germe cristallin (30).

7. Appareil de production utilisé pour le procédé de production d'un cristal de nitrure du groupe 13 selon l'une quelconque des revendications 1 à 6, comprenant :

une unité d'entraînement (32) destinée à entraîner la rotation d'au moins l'un du liquide mixte (24) et du germe cristallin (30); et

une unité de commande (34) destinée à commander l'unité d'entraînement (32) de manière à ce qu'au moins l'un du liquide mixte (24) et du germe cristallin (30) soit soumis à une rotation au cours de l'étape de croissance cristalline, la vitesse relative entre le liquide mixte (24) et le germe cristallin (30) au cours de l'étape de croissance cristalline étant soumise à des fluctuations répétées suivant un ou une pluralité de types de schémas prédéterminés, et une valeur maximale de la vitesse relative indiquée par le schéma étant de 0,01 m/s ou plus,

dans lequel une période T1 avec la vitesse relative satisfaisant une relation représentée par la Formule (1) suivante et une période T2 avec la vitesse relative satisfaisant une relation représentée par la Formule (2) suivante dans le schéma satisfont une relation représentée par la Formule (3) suivante,

$$0 \leq V < 0,01 \qquad (1)$$

$$0,01 \leq V \qquad (2)$$

$$T1 < T2 \qquad (3)$$

dans lequel dans les Formules (1) et (2), V représente la vitesse relative (m/s),

**caractérisé en ce qu'**un rapport d'une valeur maximale Vmax à une valeur minimale Vmin de la vitesse relative dans une surface de croissance principale du germe cristallin (30) au cours de l'étape de croissance cristalline satisfait une relation représentée par la Formule (4) suivante au cours de la période T2 dans le schéma,

$$Vmax/Vmin < 10 \qquad (4).$$

# FIG.1

# FIG.2

{10-11} PLANE

30

c-AXIS DIRECTION

m-PLANE

a-AXIS DIRECTION

m-AXIS DIRECTION

# FIG.3

C-AXIS
DIRECTION

{10-11} PLANE

30

L

d

# FIG.4

# FIG.5

# FIG.6

# FIG.7

Legend:
- —— RELATIVE SPEED 76A
- --- SEED SPEED 76B
- — — FLOW RATE 76C

# FIG.8

Legend:
- —— RELATIVE SPEED 77A
- --- SEED SPEED 77B
- — — FLOW RATE 77C

# FIG.9

Legend:
— RELATIVE SPEED 78A
- - - SEED SPEED 78B
- -- FLOW RATE 78C

# FIG.10

Legend:
— RELATIVE SPEED 79A
- - - SEED SPEED 79B
- -- FLOW RATE 79C

# FIG.11

P5    P5    P5    P5

| | | | |
|---|---|---|---|
| | | | |

0.06
0.05
0.04
0.03
0.02
0.01
0
-0.01
-0.02
-0.03
-0.04

0    5    10    15    20    25

80C    80B    80A

— RELATIVE SPEED 80A
--- SEED SPEED 80B
-- FLOW RATE 80C

# FIG.12

P6    P6    P6    P6

0.11
0.1
0.09
0.08
0.07
0.06
0.05
0.04
0.03
0.02
0.01
0
-0.01
-0.02
-0.03
-0.04
-0.05
-0.06
-0.07
-0.08

0    5    10    15    20    25

81B
81C

81A

— RELATIVE SPEED 81A
--- SEED SPEED 81B
-- FLOW RATE 81C

# FIG.13

P7    P7'

| | | |
|---|---|---|
| —— | RELATIVE SPEED | 82A |
| --- | SEED SPEED | 82B |
| —- | FLOW RATE | 82C |

# FIG.14

P8    P8'    P8

| | | |
|---|---|---|
| —— | RELATIVE SPEED | 83A |
| --- | SEED SPEED | 83B |
| —- | FLOW RATE | 83C |

# FIG.15

# FIG.16

# FIG.17

Legend:
— RELATIVE SPEED 86A
--- SEED SPEED 86B
— - FLOW RATE 86C

# FIG.18

Legend:
— RELATIVE SPEED 87A
--- SEED SPEED 87B
— - FLOW RATE 87C

# FIG.19

| | RELATIVE SPEED 88A |
|---|---|
| - - | MELT SPEED 88C |

# FIG.20

| | RELATIVE SPEED 89A |
|---|---|
| - - | MELT SPEED 89C |

# FIG.21

# FIG.22

# FIG.23

P17  P17  P17

```
0.05
0.04                                                    ~92A
0.03
0.02                                                    ~92C
0.01
   0
    0    5    10   15   20   25
```

—— RELATIVE SPEED 92A
--- MELT SPEED 92C

# FIG.24

P18  P18  P18  P18

```
 0.1
0.09
0.08
0.07
0.06
0.05
0.04
0.03                                                   ~93A
0.02                                                   ~93C
0.01
   0
    0    5    10   15   20   25
```

—— RELATIVE SPEED 93A
--- MELT SPEED 93C

# FIG.25

# FIG.26

# FIG.27

P21　　P21'　　P21　　P21'　　P21

0.11
0.1
0.09
0.08
0.07
0.06
0.05
0.04　　　　　　　　　　　　　　　96A
0.03
0.02
0.01
0
-0.01
-0.02　　　　　　　　　　　　　　96C
-0.03
-0.04
-0.05
-0.06
-0.07
-0.08
-0.09
-0.1
-0.11

0　　　5　　　10　　　15　　　20　　　25

――― RELATIVE SPEED 96A
－ － MELT SPEED 96C

# FIG.28

P22　　　　　P22'　　　P22

0.11
0.1
0.09
0.08
0.07
0.06　　　　　　　　　　　　　　97C
0.05
0.04
0.03
0.02
0.01
0
-0.01
-0.02　　　　　　　　　　　　　　97A
-0.03
-0.04
-0.05
-0.06
-0.07
-0.08
-0.09
-0.1
-0.11

0　　　5　　　10　　　15　　　20　　　25

――― RELATIVE SPEED 97A
－ － MELT SPEED 97C

# FIG.29

P23   P23'   P23   P23'   P23

RELATIVE SPEED 98A
MELT SPEED 98C

~ 98A

~ 98C

# FIG.30

P24  P24'  ···

99C
99A

RELATIVE SPEED 99A
MELT SPEED 99C

# FIG.31

# FIG.32

# FIG.33

P27    P27

RELATIVE SPEED 102A

SEED SPEED 102B

FLOW RATE 102C

# FIG.34

P28    P28

RELATIVE SPEED 103A

SEED SPEED 103B

FLOW RATE 103C

# FIG.35

# FIG.36

# FIG.37

# FIG.38

(A)

(B)

# FIG.39

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4189423 B
- JP 2007277055 A
- JP 2007254161 A
- JP 2010083711 A
- WO 2013021804 A1
- JP 2011213579 A
- JP 2013051056 A